Europäisches Patentamt

European Patent Office

Office européen des brevets

(19)

(11) EP 0 940 798 A1

(12) EUROPEAN PATENT APPLICATION

(43) Date of publication:
08.09.1999 Bulletin 1999/36

(51) Int Cl.$^6$: G09G 3/36

(21) Application number: 99104314.2

(22) Date of filing: 03.03.1999

(84) Designated Contracting States:
AT BE CH CY DE DK ES FI FR GB GR IE IT LI LU
MC NL PT SE
Designated Extension States:
AL LT LV MK RO SI

(30) Priority: 04.03.1998 JP 5229198

(71) Applicant: NEC CORPORATION
Tokyo (JP)

(72) Inventor: Kato, Fumihiko c/o NEC Yamagata, Ltd.
Yamagata-shi, Yamagata (JP)

(74) Representative: Glawe, Delfs, Moll & Partner
Patentanwälte
Postfach 26 01 62
80058 München (DE)

(54) Driving circuit for liquid crystal display

(57) A liquid crystal driving circuit enables output voltage to be approached toward ideal $\gamma$ curve of liquid crystal display panel while improving conventional C-DAC method liquid crystal driving circuit in which an output voltage is difficult to agree with a $\gamma$ curve. A multiplexer circuit (4) selects two voltages adjacent to each other out of a plurality of $\gamma$ correction voltages inputted from outer section based on high order P bits of input data of N bits to be displayed. A digital-analog conversion circuit (5) equally segments two $\gamma$ correction voltages therebetween selected previously into the number in answer to remaining low order bits of display data. There is provided a bit conversion circuit (2) for implementing bit number amplification of amplifying bit number of display data to F bits which is larger than N bits, and it enables two $\gamma$ correction voltages therebetween selected previously to be segmented equally into the number ($2^{F-P}$) which is larger than the conventional segmentation number $2^{N-P}$, and it enables segmentation number to be selected in answer to the value of segmented $\gamma$ correction voltage so that it causes the segmentation number to be increased in the intermediate region of the $\gamma$ correction voltage, and it causes the segmentation number to be decreased in high region and low region of the $\gamma$ correction voltage.

FIG. 5

$\downarrow$N DATA BUFFER CIRCUIT

N bits DBF — 1

$\downarrow$N BIT CONBERSION CIRCUIT

N bits
F bits — 2

F>N

DATA LATCH CIRCUIT $\downarrow$F
3

MULTIPLEXER CIRCUIT 4

F bits LAT

$\downarrow$P $\downarrow$G (P+G=F)

OUTER INPUT $\gamma$ CORRECTION POWER SOURCE X VALUES

X

MUX

TWO VALUES

G bits DAC

DIGITAL ANALOG CONVERSION CIRCUIT 5

DRIVE CIRCUIT 10

EP 0 940 798 A1

## Description

## BACKGROUND OF THE INVENTION

The present invention relates to a liquid crystal driving circuit for outputting liquid crystal drive voltage toward a liquid crystal display panel. More to particularly, this invention relates to a liquid crystal driving circuit which is provided with a capacitor array type analog-digital conversion circuit.

## Description of the Prior Art

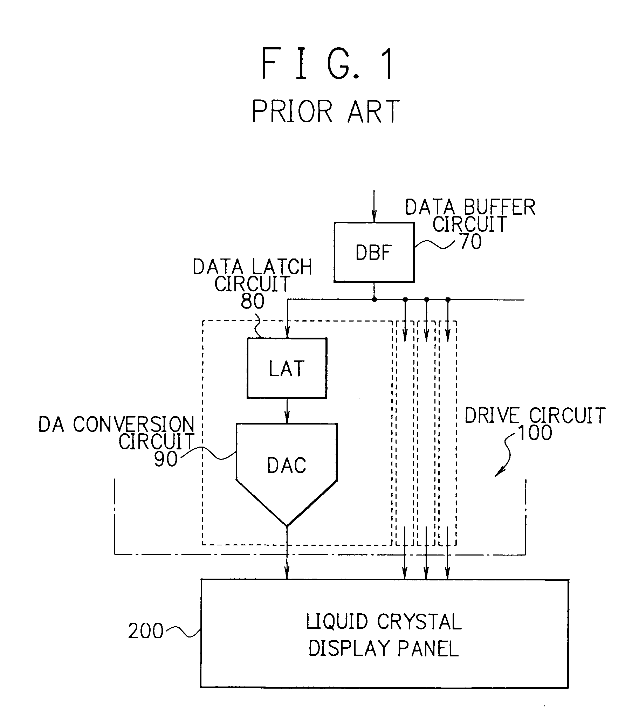

In recent years, a thin film transistor liquid crystal display panel whose characteristic is of low voltage, lightweight one, and thin type is remarked by way of a display device instead of CRT (cathode ray tube), with the advance of down sizing of the computer. Referring to Fig. 1, there is shown one of liquid crystal driving circuit which drives the thin film transistor liquid crystal display panel with the characteristic described-above. The liquid crystal driving circuit 100 holds a display data passed through a data buffer circuit (hereinafter referring to DBF) 70 at a latch circuit (hereinafter referring to LAT) 80 while remaining the display data in the state of digital signal once, thus digital processing is implemented to a digital-analog conversion circuit (hereinafter referring to DAC) 90 just in front of a liquid crystal display panel 200.

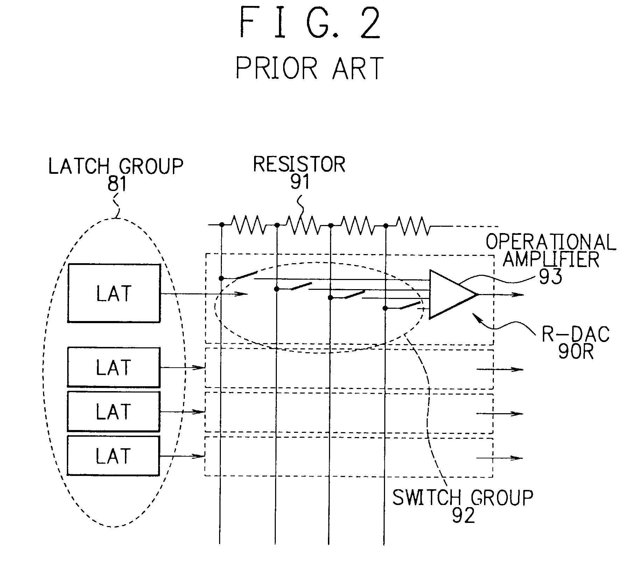

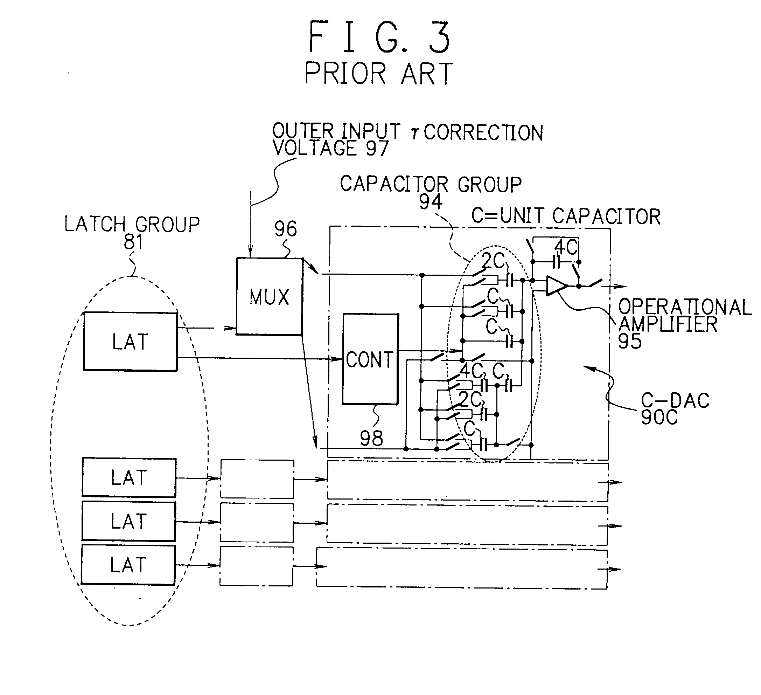

The DAC 90 has two types of the DAC, one of which is a DAC of resistor strings type (hereinafter referring to R-DAC) whose block diagram is shown in Fig. 2, and the other of which is a DAC of capacitor array type (hereinafter referring to C-DAC) whose block diagram is shown in Fig. 3. Referring to Fig. 2, the R-DAC 90R consists of a resistor 91 and switch group 92, thus obtaining required analog voltage value while permitting a switch to be ON, out of the switch group 92 depending on inputted digital data. In the liquid crystal driving circuit using the R-DAC, the digital data separated by the DBF is inputted successively to the latch group 81 once. The data is inputted to the whole LAT within the latch group 81, before data transfer is implemented from the latch group 81 to the R-DAC of the next stage. Corresponding one switch in answer to the input digital data is selected among the switch group 92 within the R-DAC 90R, thus being outputted through an operational amplifier 93 whose object is to convert an impedance.

On the other hand, referring to Fig. 3, the C-DAC 90C consists of capacitor group 94 as being weighted, and an operational amplifier 95. The C-DAC 90C obtains required voltage value while utilizing redistribution of electric charge accumulated in capacitor group 94 and characteristic of the operational amplifier 95. In the C-DAC 90C method liquid crystal driving circuit of the above configuration, the operation from the latch group 81 to the data transfer toward the next stage is the same as that of the R-DAC method liquid crystal driving circuit above described previously. Next, the data transferred from the latch group 81 to the next stage is segmented into a high order bit data and a low order bit data, thus the high order bit data is inputted to a multiplexer circuit (hereinafter referring to MUX) 96. The MUX 96 permits adjacent two voltage values to be selected out of a plurality of gamma (γ) correction voltage values 97 inputted from outer section in answer to the inputted high order bit data to implement data transfer to the C-DAC 90C of the next stage. Here, the adjacent two voltage values selected by the MUX 96 mean voltage values such as $V_3$ and $V_4$, or $V_5$ and $V_6$ if, for instance, the γ correction voltage value level is $V_0$ to $V_9$ in the direction of high voltage level. On the other hand, the low order bit data is inputted to a control circuit (hereinafter referring to CONT) 98 within the C-DAC. The CONT 98 is a circuit for operating the switch group so as to enable analog voltage value to be generated in answer to the digital data on the inside of the C-DAC. The C-DAC 90C including the CONT 98 permits the adjacent two voltage values therebetween inputted from the MUX 96 to be segmented equally, thus outputting one value thereof. For instance, if the C-DAC 90C is a C-DAC of 5 bits, it permits the selected two voltage values there between by the MUX 96 to be segmented equally into 32 equi-segmentation, thus selecting one voltage value out of voltage values segmented equally into 32, while referring to the data of 5 bits inputted to the CONT 98, to output through the operational amplifier 95.

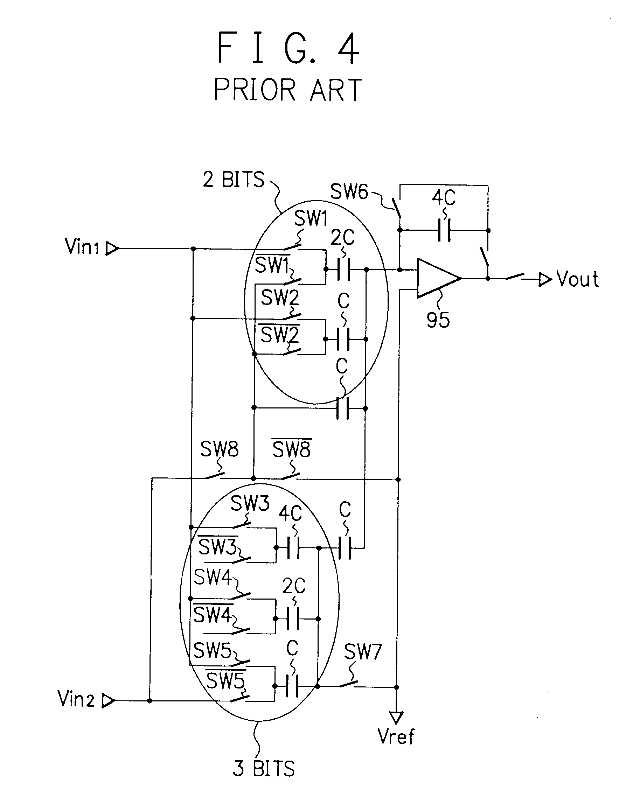

Fig. 4 is a detailed view showing the C-DAC within Fig. 3. Referring to Fig. 4, the C-DAC shown in Fig. 4 is a C-DAC consisting of 5 bits of the high order 2 bits + the low order 3 bits. The switch in the drawing implements switch operation by the signal from the CONT 98. The operation of the C-DAC of 5 bits is that data sampling is implemented, before data holding is implemented. For instance, in the case of an output of positive polarity, at the time of sampling, a SW6, a SW7 and a SW8-Bar become ON state. The switch within the high order 2 bits or within the low order 3 bits is determined by the data inputted to the CONT 98 of the front stage, thus either one thereof becomes ON state.

Next, at the time of holding, the SW6 and the SW7 become OFF state, and a SW8 becomes ON state. Further, the switch within the high order 2 bits or within the low order 3 bits is determined by the data inputted beforehand to the CONT 98 of the front stage, thus either one thereof becomes ON state.

In the case of negative polarity, at the time of sampling, the SW6, the SW7 and the SW8 become ON state. The switch within the high order 2 bits or within the low order 3 bits is determined by the data inputted to the CONT 98 of the front stage, thus either one thereof becomes ON state.

Next, at the time of holding, the SW6 and the SW7 become OFF state, and a SW8-Bar becomes ON state. Further, the switch within the high order 2 bits or within the low order 3 bits is determined by the data inputted beforehand to the CONT 98 of the front stage, thus either one thereof becomes ON state.

According to the operation described above, an output voltage $V_{out}$ of the C-DAC of 5 bits is shown by following two formulas which are to represent output voltage at the time of polarity inversion

$$V_{out} = 2V_{ref} - V_{in2} - (V_{in1} - V_{in2}) \times \alpha/32$$

$$V_{out} = V_{in2} + (V_{in1} - V_{in2}) \times \alpha/32$$

(here $\alpha = 0, 1, 2, 3, \cdots, 31$)

Here, $V_{ref}$ is a reference voltage inputted from outer section in order to perform calculation within the C-DAC. This $\alpha$ is determined by data inputted to the CONT 98. Namely, when the data is ' 0 0 0 0 0', $\alpha = 0$, while when the data is ' 1 1 1 1 1 ', $\alpha = 31$.

Here, there is described in terms of characteristic of the liquid crystal in order to facilitate comprehension of the present invention. Generally, the driving circuit of the liquid crystal display panel is necessary to implement AC driving (reversed polarity output driving) for changing output polarity in every frame in order to prevent ionization phenomenon of the liquid crystal. Namely, the AC driving is a driving method that a pixel whose first frame is positive polarity in relation to the reference voltage of the side of liquid crystal, is made on the negative polarity in relation to the reference voltage at the next frame. Consequently, the liquid crystal driving circuit, when it represents for instance, 256 gradations, as a practical matter, is necessary to be capable of being generated 512 gradations by adding gradation for positive polarity and gradation for negative polarity. Namely, it becomes necessary to prepare 512 pieces of selection switches in the R-DAC liquid crystal driving circuit of 256 gradations.

On the other hand, in the case of the liquid crystal driving circuit of the C-DAC method, as described above, it is capable of performing an inverse polarity output easily by converting switching operation of the switch group, thereby, it is unnecessary to increase switch number or unit capacitance for increasing of gradation. Namely, there is no increasing of the circuit for necessity of output driving of inverse polarity which is characteristic of the liquid crystal driving. One example of the C-DAC of such configuration is disclosed in the Japanese Patent Application No. HEI 8-027075 or the Japanese Patent Application No. HEI 9-168824 which are assigned by the same assignee as that of the present invention. The former discloses LIQUID CRYSTAL IMAGE SIGNAL CONTROL METHOD AND CONTRL CIRCUIT. The latter discloses SWITCHED CAPACITOR TYPE DA CONVERSION CIRCUIT AND CONTRL METHOD THEREOF AND LCD DRIVING CONTROL CIRCUIT AND LCD DRIVING CONTROL METHOD.

Furthermore, the liquid crystal has another one characteristic that there exists special curve of $\gamma$ curve because transmittance of light in relation to applied voltage is not fixed. For that reason, in the liquid crystal driving circuit, it is necessary to implement $\gamma$ correction so as to adjust to the $\gamma$ curve. The characteristic of the $\gamma$ curve is that the shape of the curve is different depending on the applied voltage applying to the liquid crystal. The transmittance of light is varied abruptly at the portion where the applied voltage is high or low in response to the reference voltage of the side of the liquid crystal, however, the transmittance of light is varied relatively inactive at intermediate voltage region of the applied voltage.

The characteristic of the R-DAC method liquid crystal driving circuit shown in Fig. 2 is to enable faithful color to be reproduced by segmenting the resistor 91 so as to adjust to the $\gamma$ curve of the liquid crystal display panel. However, it is necessary to prepare selection switch for the number of gradations. For instance, in the liquid crystal driving circuit of 8 bits in order to reproduce 256 gradations, it is necessary to prepare 512 pieces of switches including switch for frame change of polarity inversion. For that reason, the area increasing of the circuit with increasing of gradation becomes important problem.

On the other hand, the characteristic of the liquid crystal driving circuit using the C-DAC shown in Fig. 3 is to enable unit capacitance number necessary for normal case to be reduced by further segmenting the C-DAC 90C of some bit numbers at the internal section. The C-DAC 90C shown in Figs. 3 and 4 is the C-DAC of 5 bits. Under normal conditions, 64 pieces of unit capacitance becomes necessary for the C-DAC of 5 bits, however, as shown in the drawing, it is capable of reducing unit capacitance to 16 pieces by segmenting the C-DAC of 5 bits into the high order 2 bits + the low order 3 bits. Since it is capable of being implemented the polarity inversion in every frame by changing driving method thereof, that is the characteristic of the C-DAC, it is possible to perform the inverse polarity output without area increasing.

Thus, according to the liquid crystal driving circuit using the C-DAC, it is capable of being suppressed area increasing with increasing of the bit number. However, in the conventional C-DAC, it is capable of segmenting the $\gamma$ correction voltage value 97 of the outer input selected by MUX 96 into the only equi-segmentation depending on certain predetermined coefficient. For instance, in the normal liquid crystal driving circuit of 8 bits, there is segmented equally two voltage values therebetween selected by the MUX 96 into 32 equi-segmentation by the C-DAC while preparing the C-DAC of 5 bits. However since the equi-segmentation always follows a certain coefficient (this case; 32 equi-segmentation), it is difficult to adjust to the $\gamma$ curve of the liquid crystal. In order to adjust the output voltage to the $\gamma$ curve of the

liquid crystal, on the one hand it is necessary to obtain straight like output at the center of applied voltage, on the other hand it is necessary to obtain curved output at the high portion or low portion of the applied voltage.

Namely, in the driving circuit using the R-DAC, area increasing with increasing of bit number becomes problem, while in the driving circuit using the C-DAC, color reproduction becomes disadvantageous because $\gamma$ correction is difficult.

## SUMMARY OF THE INVENTION

In view of the foregoing, it is an object of the present invention in order to achieve the above problem to provide a liquid crystal driving circuit which enables the output of the C-DAC to be further approached toward $\gamma$ curve of the liquid crystal display panel in the liquid crystal driving circuit using the C-DAC.

According to a first aspect of the present invention, in order to achieve the above-mentioned object, there is provided a liquid crystal driving circuit which is provided with a capacitance array type digital analog conversion circuit selecting two voltages adjacent to each other out of a plurality of $\gamma$ correction voltages which are inputted from an outer section in accordance with high order P bits of input data of N bits to be displayed, and the digital-analog conversion circuit generates $2^N$ pieces of voltages from the input data of N bits by equally segmenting two $\gamma$ correction voltages therebetween into the corresponding number in answer to remaining low order bit of the input data to be displayed, thus outputting one of $2^N$ pieces of voltages by way of a liquid crystal drive voltage, the liquid crystal driving circuit comprises a bit conversion circuit for amplifying bit number in terms of bit number of the input data to be displayed to F bits which is larger than N bits, so that there can be equally segmented two $\gamma$ correction voltages therebetween selected previously into $2^{F-P}$ equisegmentation, which is larger than $2^{N-P}$.

According to a second aspect of the present invention, there is provided a liquid crystal driving circuit which comprises a data buffer circuit with N bits provided with input terminal of N bits and output terminal of N bits for performing data transfer of input data with N bits to be displayed, which is inputted to the input terminal toward circuit of next stage connected to the output terminal, a bit conversion circuit provided with input terminal of N bits and output terminal of N bits for performing bit number amplification of bit number of N bit data in terms of bit number of data with N bits outputted by the data buffer circuit to F bits which is larger than N bits while connecting to the output terminal of the data buffer circuit, a data latch circuit provided with input terminal of F bits and output terminal of F bits for maintaining data of F bits which the bit conversion circuit outputs while connecting to the output terminal of the bit conversion circuit, a multiplexer which is connected both to high order P bits data of output bit of the data latch circuit

and outer $\gamma$ correction power source device outputting a plurality of $\gamma$ correction voltage for selecting two voltages adjacent to each other concerning voltage value out of the plurality of $\gamma$ correction voltages which the $\gamma$ correction power source device outputs while referring to the high order P bit data transferred from the data latch circuit, thus transferring analog voltage selected previously to a next stage, and a digital-analog conversion circuit of capacitance array type with G bits taking two analog voltage signals outputted from the multiplexer circuit and low order G bits data (G=F-P) of F bits output outputted by the data latch circuit as input, for segmenting two analog voltage signals therebetween outputted from the multiplexer circuit equally, and for outputting liquid crystal drive voltage value in answer to input data out of voltage values segmented equally depending on the input data from the data latch circuit, wherein there is established G as being G = F-P > N-P, thereby, it enables two $\gamma$ correction voltages therebetween selected by the multiplexer circuit to be segmented equally into the number which is larger than $2^{N-P}$.

As stated above, according to the present invention, it causes bit number to be increased within the circuit. Conventional liquid crystal driving circuit of the C-DAC method is capable of outputting by only equisegmentation in accordance with a certain coefficient. For instance, when the data to be displayed is 8 bits, formerly, the 8 bits is segmented into the high order 3 bits and the low order 5 bits. There is equally segmented two $\gamma$ correction voltages therebetween from the outer section into 32 equi-segmentation, which two $\gamma$ correction voltages the MUX 96 selects while referring to the high order 3 bits by using the C-DAC of 5 bits. Namely, conventional liquid crystal driving circuit of the C-DAC method is capable of outputting by only 32 equi-segmentation. The liquid crystal driving circuit of the present invention is provided with the bit conversion circuit which amplifies the bit number of the above display data from 8 bits to 9 bits. The bit conversion circuit enables the number of low order bit to increase to be segmented in to 6 bits from 5 bits such that there is segmented the display data into the high order 3 bits and the low order 6, thus causing the maximum segmentation number of the $\gamma$ correction voltage to be increased to 64 from the conventional 32. The liquid crystal driving circuit enables the output voltage of the C-DAC to be approached to the ideal $\gamma$ curve of the liquid crystal display panel while selecting the segmentation number out of 8 equisegmentation, 16 equi-segmentation, 32 equi-segmentation, and 64 equi-segmentation.

The above and further objects and novel features of the invention will be more fully understood from the following detailed description when the same is read in connection with the accompanying drawings. It should be expressly understood, however, that the drawings are for purpose of illustration only and are not intended as a definition of the limits of the invention.

## BRIEF DESCRIPTION OF THE DRAWINGS

Fig. 1 is a block diagram showing a general configuration of a liquid crystal driving circuit;

Fig. 2 is a block diagram showing a configuration of the liquid crystal driving circuit of R-DAC method;

Fig. 3 is a block diagram showing a configuration of a conventional C-DAC method liquid crystal driving circuit;

Fig. 4 is a detailed circuit view of the C-DAC;

Fig. 5 is a block diagram showing a configuration of the liquid crystal driving circuit according to a first embodiment of the present invention;

Fig. 6 is a block diagram showing a case where display data is 8 bits in the first embodiment;

Fig. 7 is a block diagram showing a configuration of the liquid crystal driving circuit according to a second embodiment;

Fig. 8 is a view showing a conversion table of 8 bits to 9 bits in the cases where there is segmented equally $V_0$ to $V_1$ therebetween into 16 equi-segmentation, and there is segmented equally $V_1$ to $V_2$ therebetween into 16 equi-segmentation, corresponding to Fig. 6;

Fig. 9 is a view showing a conversion table of 8 bits to 9 bits in the cases where there is segmented equally $V_2$ to $V_3$ therebetween into 32 equi-segmentation, corresponding to Fig. 6;

Fig. 10 is a view showing a conversion table of 8 bits to 9 bits in the cases where there is segmented equally $V_3$ to $V_4$ therebetween into 64 equi-segmentation, corresponding to Fig. 6;

Fig. 11 is a view showing a conversion table of 8 bits to 9 bits in the cases where there is segmented equally $V_4$ to $V_5$ therebetween into 64 equi-segmentation, corresponding to Fig. 6;

Fig. 12 is a view showing a conversion table of 8 bits to 9 bits in the cases where there is segmented equally $V_5$ to $V_6$ therebetween into 32 equi-segmentation, corresponding to Fig. 6;

Fig. 13 is a view showing a conversion table of 8 bits to 9 bits in the cases where there is segmented equally $V_6$ to $V_7$ therebetween into 16 equi-segmentation, and there is segmented equally $V_7$ to $V_8$ therebetween into 16 equi-segmentation, corresponding to Fig. 6;

Fig. 14 is a view showing a conversion table of 8 bits to 9 bits in the cases where there is segmented equally $V_0$ to $V_1$ therebetween into 32 equi-segmentation;

Fig. 15 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 16 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 17 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 18 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 19 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 20 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 21 is a view showing a conversion table of 8 bits to 9 bits in the cases where there is segmented equally $V_1$ to $V_2$, $V_2$ to $V_3$, $V_3$ to $V_4$, $V_4$ to $V_5$, $V_5$ to $V_6$, $V_6$ to $V_7$, and $V_7$ to $V_8$, therebetween respectively into 32 equi-segmentation;

Fig. 22 is a view showing a conversion table of 8 bits to 9 bits in the cases where there is segmented equally $V_0$ to $V_1$ therebetween into 16 equi-segmentation;

Fig. 23 is a view showing a conversion table of 8 bits to 9 bits in the cases where there is segmented equally $V_1$ to $V_2$ therebetween into 32 equi-segmentation;

Fig. 24 is a view showing a conversion table of 8 bits to 9 bits in the cases where there is segmented equally $V_2$ to $V_3$ therebetween into 32 equi-segmentation;

Fig. 25 is a view showing a conversion table of 8 bits to 9 bits in the cases where there is segmented equally $V_2$ to $V_3$ therebetween into 64 equi-segmentation;

Fig. 26 is a view showing a conversion table of 8 bits to 9 bits in the cases where there is segmented equally $V_4$ to $V_5$ therebetween into 32 equi-segmentation;

Fig. 27 is a view showing a conversion table of 8 bits to 9 bits in the cases where there is segmented equally $V_5$ to $V_6$ therebetween into 32 equi-segmentation;

Fig. 28 is a view showing a conversion table of 8 bits to 9 bits in the cases where there is segmented equally $V_6$ to $V_7$ therebetween into 32 equi-segmentation; and

Fig. 29 is a view showing a conversion table of 8 bits to 9 bits in the cases where there is segmented equally $V_7$ to $V_8$ therebetween into 16 equi-segmentation.

## DETAILED DESCRIPTION OF THE PREFERRED EMBODIMENTS

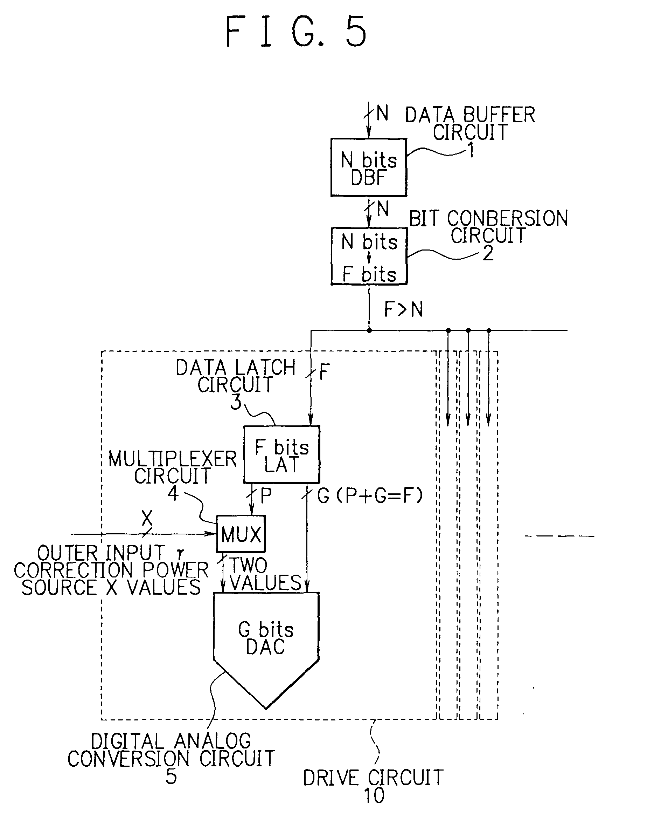

A preferred embodiment of the present invention now will be described in detail in accordance with the accompanying drawings. Fig. 5 is a block diagram showing a configuration of a liquid crystal driving circuit according to a first embodiment of the present invention. Referring to Fig. 5, an N-bit data buffer circuit 1 is provided with an N-bit input terminal and an N-bit output terminal, thus transferring an N-bit input data toward a bit conversion circuit 2 of next stage.

The bit conversion circuit 2 is provided with an N-bit input terminal and an F-bit output terminal (only F>N) which are connected to the output terminal of the data buffer circuit 1, so that the bit conversion circuit 2 causes the input bit number of the N-bit to be amplified toward the bit number to the F-bit as occasion demands.

A data latch circuit 3 is provided with F-bits input terminals and F-bits output terminals which are connected to the out put terminal of the bit conversion circuit 2, thus holding the inputted data of the F-bits.

A multiplexer circuit 4 is connected to a high order P-bit data of the output data of the F-bit data latch circuit 3, and to an outer input $\gamma$ correction power source (not illustrated) outputting x pieces of voltage values. The multiplexer circuit 4 selects adjacent two voltage values out of x pieces of voltage values of the outer input $\gamma$ correction power source while referring to the high order P-bit data transferred from the data latch circuit 3, thus transferring an analog voltage value selected previously to the next stage.

A digital-analog conversion circuit 5 is G-bit of capacitor array type conversion circuit. There are taken two analog voltage signals outputted from the multiplexer circuit 4 and low order G-bit data (G=F-P) out of the F-bit output outputted by the data latch circuit 3. The digital-analog conversion circuit 5 segments equally the two analog voltage signals outputted from the multiplexer circuit 4, thus outputting a liquid crystal drive voltage value in answer to the input data from the voltage value segmented equally based on the input data from the data latch circuit 3.

Hereinafter, there will be described operation of the present embodiment. Generally, an output voltage $V_{out}$ of an N-bit C-DAC is represented by following two formulas. The following two formulas are output voltage at the time of polarity inversion.

$$V_{out} = 2V_{ref} - V_0 - (V_1 - V_0) \times \alpha/n$$

$$V_{out} = V_0 + (V_1 - V_0) \times \alpha/n$$

($\alpha = 0, 1, 2, 3, \cdots,$     $n-1$   $n = 2^N$)

Here, $V_{ref}$ is a reference voltage inputted from outer section in order to implement calculation at the inside of the C-DAC, and $V_0$, and $V_1$ are $\gamma$ correction voltage inputted from outer input. For instance, in the case of the C-DAC of 5 bits, the $V_{out}$ is represented following formula:

$$V_{out} = 2V_{ref} - V_0 - (V_1 - V_0) \times \alpha/32$$

$$V_{out} = V_0 + (V_1 - V_0) \times \alpha/32$$

($\alpha = 0, 1, 2, \cdots, 31$)

Consequently, from the above formula, in the case of the C-DAC of 5 bits, there is understood that it permits voltage difference between $V_0$ and $V_1$ to be segmented equally into 32 equi-segmentation with $V_{ref}$ as the reference voltage.

In general, in the case of the liquid crystal driving circuit of 256 gradations (8-bit precision), there is prepared 9 pieces of the voltage values of $V_0$ to $V_8$ by way of the $\gamma$ correction voltage inputted from the outer section. The C-DAC of 5 bits divides equally $V_0$ to $V_1$ therebetween into 32 equi-segmentation, $V_1$ to $V_2$ therebetween into 32 equi-segmentation, $V_2$ to $V_3$ therebetween into 32 equi-segmentation, $\cdots$, $V_7$ to $V_8$ therebetween into 32 equi-segmentation, finally, realizing 256 gradations while dividing equally the $\gamma$ correction voltage $V_0$ to $V_8$ therebetween from the outer section into 256 equi-segmentation by 32 equi-segmentation $\times$ 8.

In the present embodiment, by way of one example, the C-DAC causes $V_0$ to $V_1$ therebetween to be segmented equally into 16 equi-segmentation. The C-DAC causes $V_1$ to $V_2$ therebetween to be segmented equally into 16 equi-segmentation. The C-DAC causes $V_2$ to $V_3$ therebetween to be segmented equally into 32 equi-segmentation. The C-DAC causes $V_3$ to $V_4$ therebetween to be segmented into 64 equi-segmentation. The C-DAC causes $V_4$ to $V_5$ therebetween to be segmented into 64 equi-segmentation. The C-DAC causes $V_5$ to $V_6$ therebetween to be segmented into 32 equi-segmentation. The C-DAC causes $V_6$ to $V_7$ therebetween to be segmented into 16 equi-segmentation. The C-DAC causes $V_7$ to $V_8$ therebetween to be segmented into 16 equi-segmentation. As a result thereof, the C-DAC causes $V_0$ to $V_8$ therebetween to be segmented into 256 equi-segmentation in total. Namely, it permits 256 gradation voltage outputted previously to be approached toward the $\gamma$ curve of the liquid crystal by varying number of segmentation of two adjacent voltages among 9 pieces of $\gamma$ correction voltages $V_0$, $\cdots$, $V_8$.

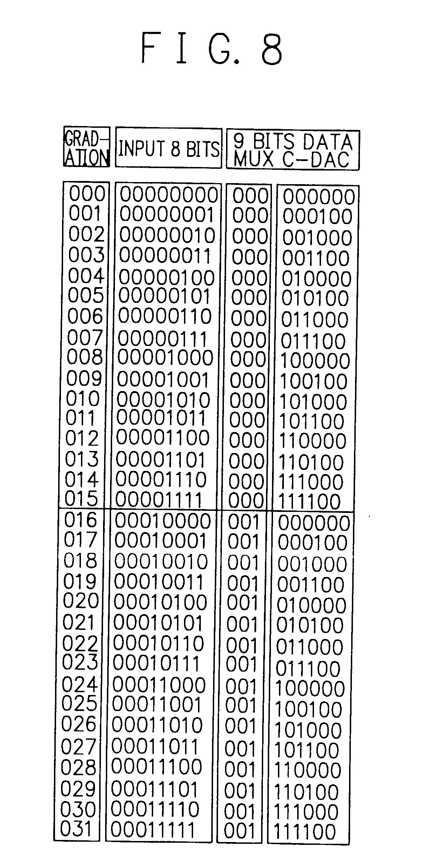

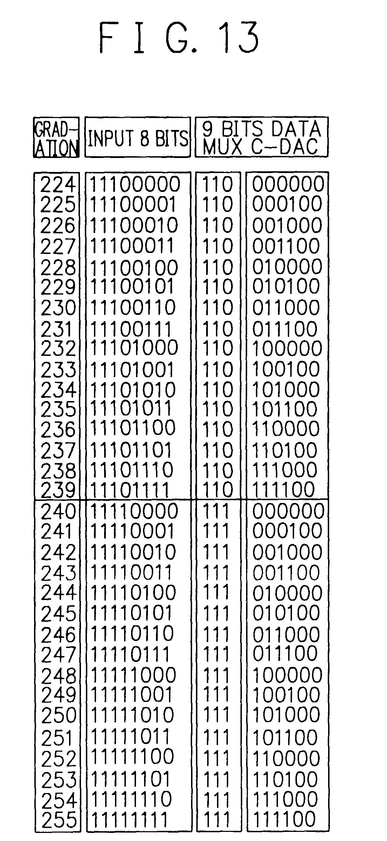

In order to realize the above described segmentation method, it is necessary to implement amplification of bit number by the N-bit F-bit conversion circuit 2 as shown in table 1 (Fig. 8) to table 6 (Fig. 13). Further, due to the convenience of the following description, Fig.

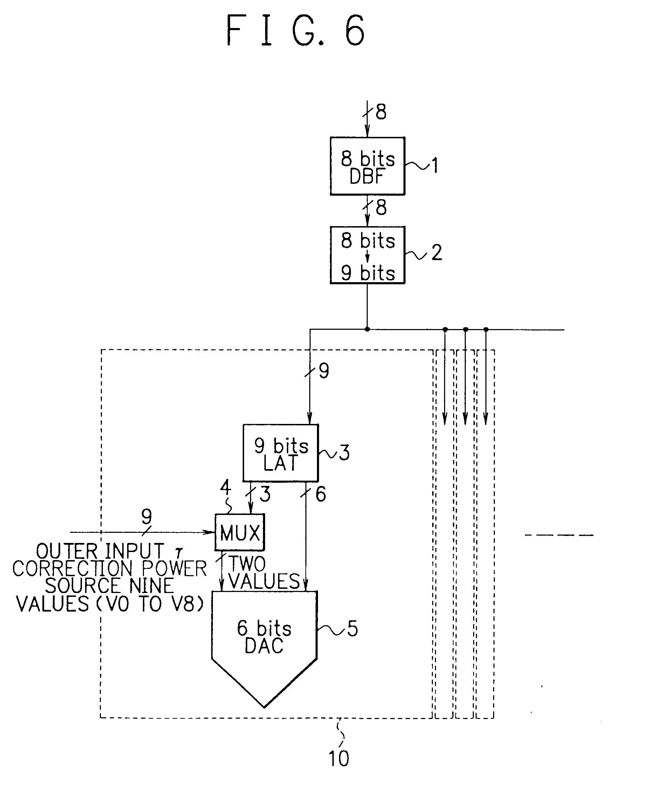

6 is a block diagram into which concrete numeral value is substituted in terms of the cases where on the assumption that 256 gradations are realized by the present embodiment, there is converted 8 bits to 9 bits, thus segmentation of the 9 bits into the high order 3 bits and the low order 6 bits. Referring to Fig. 6 and table 1 to table 6, table 1 (Fig. 8) is a table showing a conversion method of 8 bits to 9 bits in the cases where there is segmented equally $V_0$ to $V_1$ therebetween into 16 equi-segmentation, and there is segmented equally $V_1$ to $V_2$ therebetween into 16 equi-segmentation, corresponding to Fig. 6. Firstly, there is judged the high order 3 bits in order to input to the multiplexer circuit 4 from the high order 4 bits of the input 8 bits. When the high order 4 bits are ' 0 0 0 0 ', there is inputted '0 0 0' to the multiplexer 4. When the high order 4 bits are ' 0 0 0 1 ', there is inputted ' 0 0 1 'to the multiplexer circuit 4.

Next, there will be described creation method of the low order 6 bits in order to input to the digital-analog conversion circuit 5. In the case of 16 equi-segmentation, it is proper that the low order 2 bits among the low order 6 bits are ' 0 0 'when the equi-segmentation is 16 equi-segmentation. Consequently, there is used the low order 4 bits of the input 8 bits as the high order 4 bits of the low order 6 bits as they are, furthermore, adding' 0 0 ' to the low order 2 bits to input toward the digital-analog circuit 5.

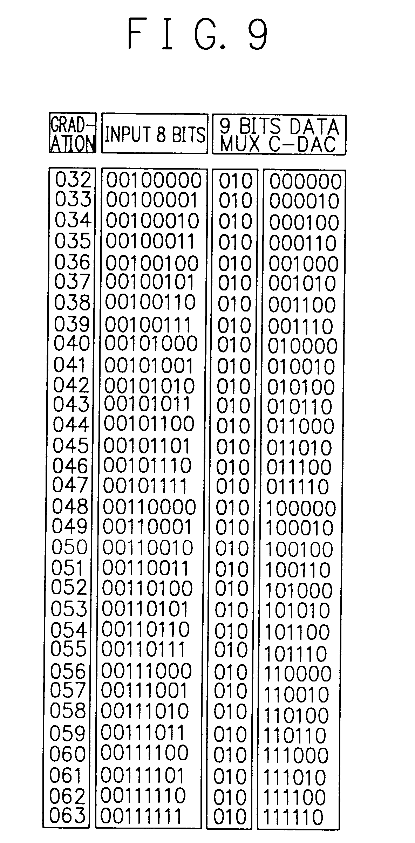

The table 2 (Fig. 9) is a table showing conversion method of 8 bits to 9 bits in cases where there is segmented equally $V_2$ to $V_3$ therebetween into 32 equi-segmentation corresponding to Fig. 6. Firstly, there is judged the high order 3 bits in order to input to the multiplexer circuit 4 from the high order 4 bits of the input 8 bits. When the high order 4 bits are ' 0 0 1 0 ' and' 0 0 1 1 ', there is inputted ' 0 1 0' to the multiplexer circuit 4.

Next, there will be described creation method of the low order 6 bits in order to input to the digital-analog conversion circuit 5. When the equi-segmentation is 32 equi-segmentation, it is suitable that low order 1 bit among the low order 6 bits is ' 0 '. Consequently, there is used the low order 5 bits of the input 8 bits as the high order 5 bits of the low order 6 bits as they are, furthermore, there is added ' 0 ' to the low order 1 bit thereof, thus inputting to the digital-analog conversion circuit 5.

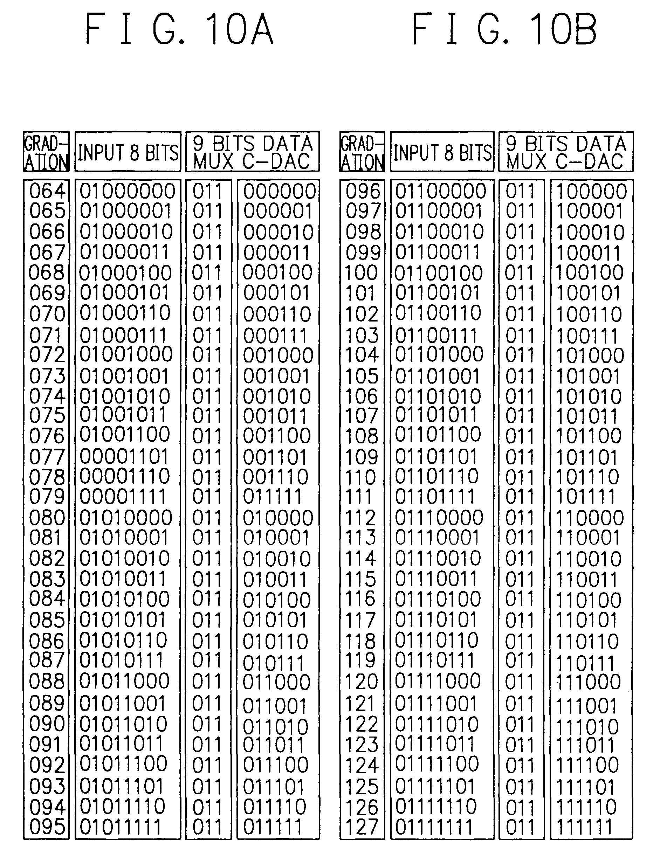

The table 3A (Fig. 10A), and the table 3B (Fig. 10B) are tables showing conversion method of 8 bits to 9 bits in cases where there is segmented equally $V_3$ to $V_4$ therebetween into 64 equi-segmentation. Firstly, there is judged the high order 3 bits in order to input to the multiplexer circuit 4 from the high order 4 bits of the input 8 bits. When the high order 4 bits are ' 0 1 0 0', ' 0 1 0 1 ', '0 1 1 0 ', and '0 1 1 1 ', there is inputted' 0 1 1 'toward the multiplexer circuit 4.

Next, there will be described a creation method of the low order 6 bits in order to input to the digital-analog conversion circuit 5. When the equi-segmentation is 64 equi-segmentation, there is inputted the low order 6 bits as they are, toward the digital-analog conversion circuit 5.

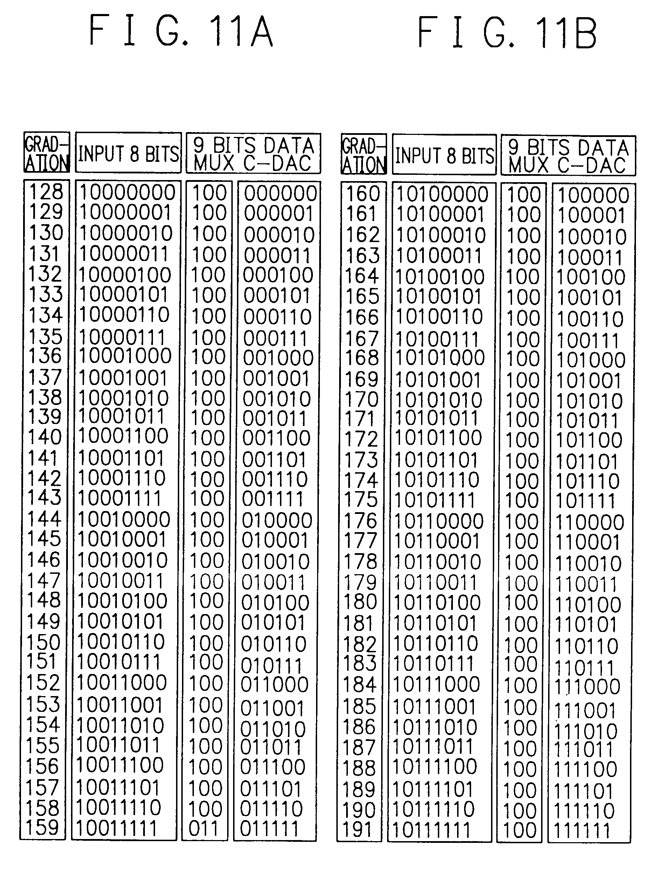

The table 4A (Fig. 11A), and the table 4B (Fig. 11B) are tables showing conversion method of 8 bits to 9 bits in cases where there is segmented equally $V_4$ to $V_5$ therebetween into 64 equi-segmentation. Firstly, there is judged the high order 3 bits in order to input to the multiplexer circuit 4 from the high order 4 bits of the input 8 bits. When the high order 4 bits are ' 1 0 0 0', ' 1 0 0 1 ', ' 1 0 1 0', and ' 1 0 1 1', there is inputted' 1 0 0 ' toward the multiplexer circuit 4.

Next, there will be described a creation method of the low order 6 bits in order to input to the digital-analog conversion circuit 5. When the equi-segmentation is 64 equi-segmentation, there is inputted the low order 6 bits as they are, toward the digital-analog conversion circuit 5.

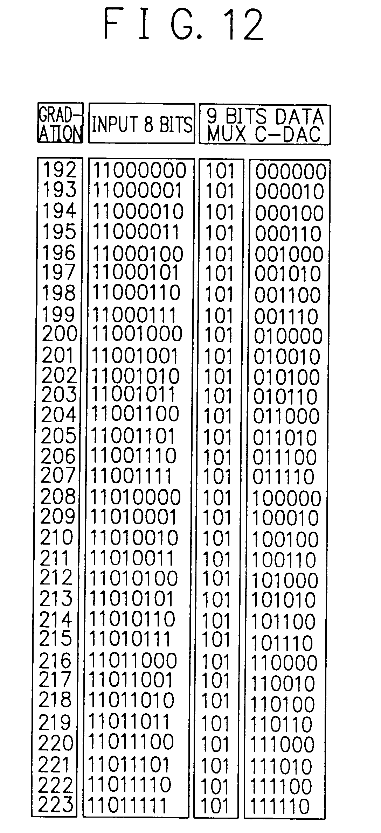

The table 5 (Fig. 12) is a table showing a conversion method of 8 bits to 9 bits in cases where there is segmented equally $V_5$ to $V_6$ therebetween into 32 equi-segmentation, corresponding to Fig. 6.

There is judged the high order 3 bits in order to input to the multiplexer circuit 4 from the high order 4 bits of the input 8 bits. When the high order 4 bits are ' 1 1 0 0 ', and' 1 1 0 1 ', there is inputted' 1 0 1 ' toward the multiplexer circuit 4.

Next, there will be described creation method of the low order 6 bits in order to input to the digital-analog conversion circuit 5. When the equi-segmentation is 32 equi-segmentation, it is suitable that low order 1 bit among the low order 6 bits is ' 0 '. Consequently, there is used the low order 5 bits of the input 8 bits as the high order 5 bits of the low order 6 bits as they are, furthermore, there is added '0 ' to the low order 1 bit thereof, thus inputting to the digital-analog conversion circuit 5.

The table 6 (Fig. 13) is a table showing a conversion method of 8 bits to 9 bits in the cases where there is segmented equally $V_6$ to $V_7$ therebetween into 16 equi-segmentation, and there is segmented equally $V_7$ to $V_8$ therebetween into 16 equi-segmentation, corresponding to Fig. 6. Firstly, there is judged the high order 3 bits in order to input to the multiplexer circuit 4 from the high order 4 bits of the input 8 bits. When the high order 4 bits are ' 1 1 1 0', there is inputted' 1 1 0' to the multiplexer 4. When the high order 4 bits are ' 1 1 1 1 ', there is inputted' 1 1 1 ' to the multiplexer circuit 4.

Next, there will be described creation method of the low order 6 bits in order to input to the digital-analog conversion circuit 5. In the case of 16 equi-segmentation, it is proper that the low order 2 bits among the low order 6 bits are ' 0 0' when the equi-segmentation is 16 equi-segmentation. Consequently, there is used the low order 4 bits of the input 8 bits as the high order 4 bits of the low order 6 bits as they are, furthermore, adding ' 0 0 ' to the low order 2 bits to input toward the digital-analog circuit 5.

When there is implemented the above described segmentation, it is necessary to prepare the C-DAC of 6 bits, because $V_3$ to $V_4$ therebetween and $V_4$ to $V_5$ therebetween are of the 64 equi-segmentation. Namely, in the conventional 8 bits liquid crystal driving circuit, the C-DAC of 5 bits is used, however, in the present embodiment, it is necessary to prepare the C-DAC whose bit number is amplified to 6 bits. An output voltage of the D-DAC of 6 bits is represented by the following two formulas:

$$Vout = 2Vref - Vm - (Vm+1 - Vm) \times \alpha/64$$

$$Vout = \quad Vm + (Vm+1 - Vm) \times \alpha/64$$

$(\alpha = 0, 1, 2, 3, \cdots, 63 \qquad m = 0, 1, 2, \cdots 7)$

The formulas mean that there is segmented equally two voltages therebetween into 64 equi-segmentation. In the case of the present embodiment, since $V_0$ to $V_1$ therebetween is segmented equally into 16 equi-segmentation, the value of $\alpha$ takes 0, 4, 8, $\cdots$. Since $V_2$ to $V_3$ and $V_5$ to $V_6$ therebetween are segmented equally into 32 equi-segmentation, the value of $\alpha$ takes 0, 2, 4, 6, 8, $\cdots$.

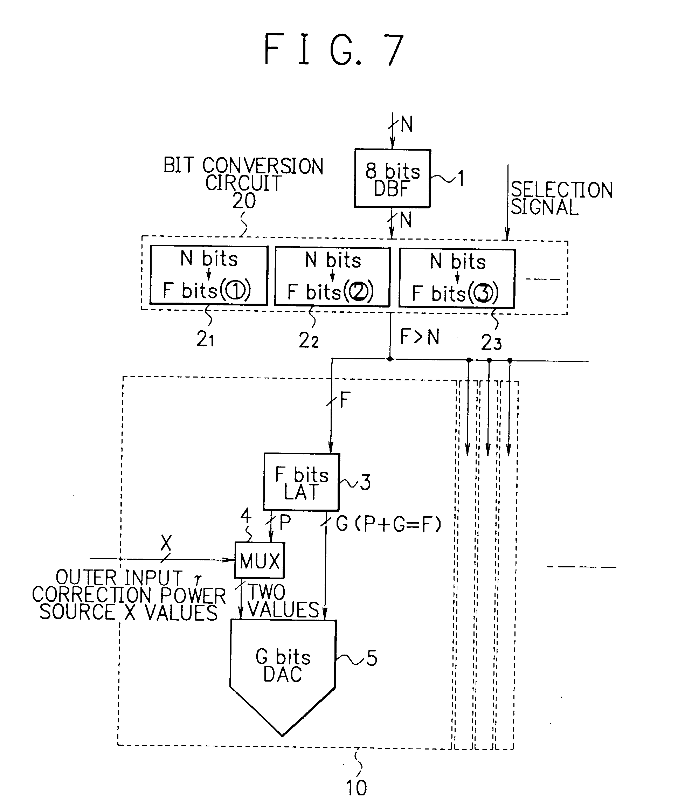

Next, there will be described a second embodiment of the present invention. Fig. 7 is a block diagram showing the liquid crystal driving circuit according to the second embodiment. The N-bit-F-bit conversion circuit 20 of the present embodiment differs from that of the first embodiment in that there are provided with a large number of the N-bit-F-bit conversion circuit (referring to Fig. 5) which is the same circuit as that of the first embodiment. The output data formalities of respective bit conversion circuits of a first bit conversion circuit 21, a second bit conversion circuit 22, a third bit conversion circuit 23, a fourth bit conversion circuit 24, $\cdots$, and so forth are different from mutually. Toward the latch circuit 3 of the next stage, a selection signal from the outer section causes one of a large number of the N-bit-F-bit conversion circuits to be selected to implement a data input depending on the selection signal from the outer section. For that reason, the data formality to be inputted to the latch circuit 3 is capable of being selected out of many kinds of output data with respective different characteristic.

In the present embodiment, there are provided many kinds of the bit number conversion circuits. The 256 gradations are constituted in such a way that there is equally segmented $V_0$ to $V_1$ therebetween into 32 equi-segmentation, $V_1$ to $V_2$ therebetween into 32 equi-segmentation, $V_2$ to $V_3$ therebetween into 32 equi-segmentation, $V_3$ to $V_4$ therebetween into 32 equi-segmentation, $V_4$ to $V_5$ therebetween into 32 equi-segmentation, $V_5$ to $V_6$ therebetween into 32 equi-segmentation, $V_6$ to $V_7$ therebetween into 32 equi-segmentation, and $V_7$ to $V_8$ therebetween into 32 equi-segmentation by the C-DAC, depending on the selection signal inputted from the outer section. Furthermore, the 256 gradations are constituted in such a way that there is equally segmented $V_0$ to $V_1$ therebetween into 16 equi-segmentation, $V_1$ to $V_2$ therebetween into 16 equi-segmentation, $V_2$ to $V_3$ therebetween into 32 equi-segmentation, $V_3$ to $V_4$ therebetween into 64 equi-segmentation, $V_4$ to $V_5$ therebetween into 64 equi-segmentation, $V_5$ to $V_6$ therebetween into 32 equi-segmentation, $V_6$ to $V_7$ therebetween into 16 equi-segmentation, and $V_7$ to $V_8$ therebetween into 16 equi-segmentation by the C-DAC, depending on the selection signal inputted from the outer section. Moreover, the 256 gradations are constituted in such a way that there is equally segmented $V_0$ to $V_1$ therebetween into 16 equi-segmentation, $V_1$ to $V_2$ therebetween into 32 equi-segmentation, $V_2$ to $V_3$ therebetween into 32 equi-segmentation, $V_3$ to $V_4$ therebetween into 64 equi-segmentation, $V_4$ to $V_5$ therebetween into 32 equi-segmentation, $V_5$ to $V_6$ therebetween into 32 equi-segmentation, $V_6$ to $V_7$ therebetween into 32 equi-segmentation, and $V_7$ to $V_8$ therebetween into 16 equi-segmentation by the C-DAC, depending on the selection signal inputted from the outer section.

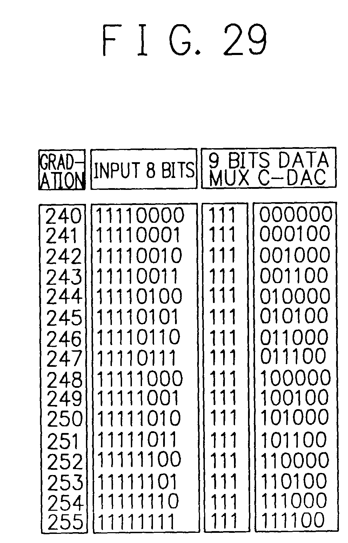

In order to realize above described segmentation method, it is necessary to implement bit number amplification by the N-bit-F-bit conversion circuit 20 as shown in table 1 (Fig. 8) to table 22 (Fig. 29).

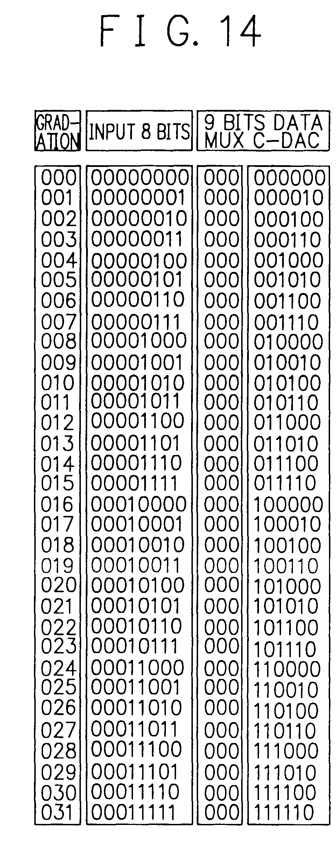

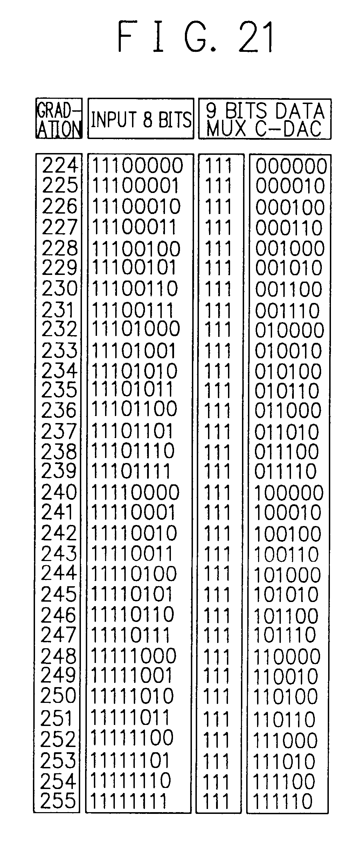

Firstly, table 7 (Fig. 14) to table 14 (Fig. 21) show that there is equally segmented $V_0$ to $V_1$ therebetween into 32 equi-segmentation, $V_1$ to $V_2$ therebetween into 32 equi-segmentation, $V_2$ to $V_3$ therebetween into 32 equi-segmentation, $V_3$ to $V_4$ therebetween into 32 equi-segmentation, $V_4$ to $V_5$ therebetween into 32 equi-segmentation, $V_5$ to $V_6$ therebetween into 32 equi-segmentation, $V_6$ to $V_7$ therebetween into 32 equi-segmentation, and $V_7$ to $V_8$ therebetween into 32 equi-segmentation.

Table 7 (Fig. 14) is a table showing a conversion method of 8 bits to 9 bits in cases where there is equally segmented $V_0$ to $V_1$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

Next, there will be described creation method of the low order 6 bits in order to input to the digital-analog conversion circuit 5. When the equi-segmentation is 32 equi-segmentation, it is suitable that low order 1 bit among the low order 6 bits is ' 0'. Consequently, there is used the low order 5 bits of the input 8 bits as the high order 5 bits of the low order 6 bits as they are, furthermore, there is added ' 0' to the low order 1 bit thereof, thus inputting to the digital-analog conversion circuit 5.

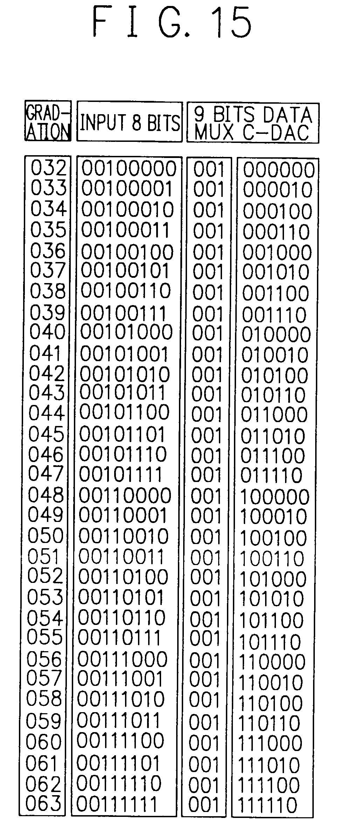

Table 8 (Fig. 15) is a table showing a conversion method of 8 bits to 9 bits in cases where there is equally segmented $V_1$ to $V_2$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

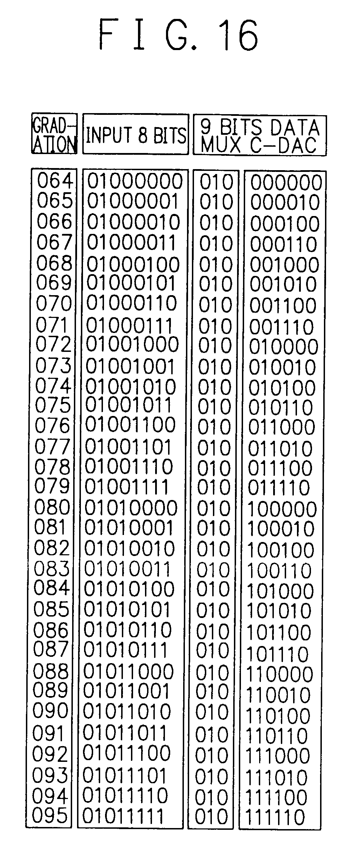

Table 9 (Fig. 16) is a table showing a conversion method of 8 bits to 9 bits in cases where there is equally segmented $V_2$ to $V_3$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

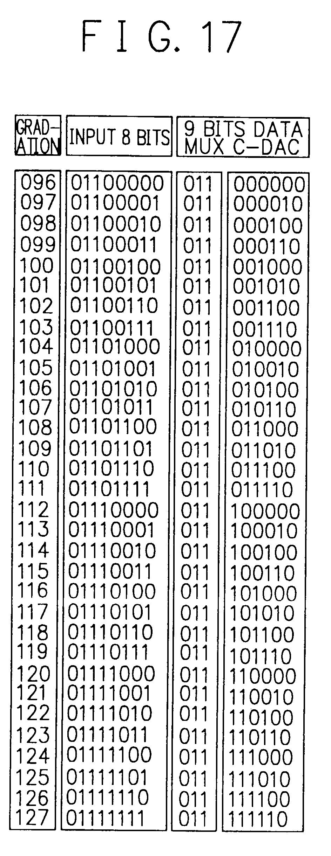

Table 10 (Fig. 17) is a table showing a conversion method of 8 bits to 9 bits in cases where there is equally segmented $V_3$ to $V_4$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

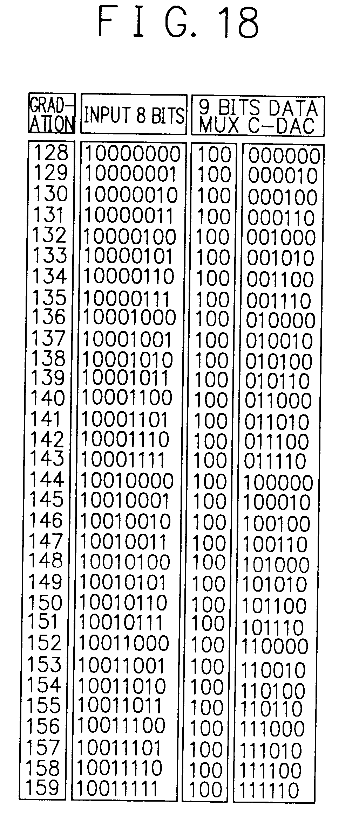

Table 11 (Fig. 18) is a table showing a conversion method of 8 bits to 9 bits in cases where there is equally segmented $V_4$ to $V_5$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

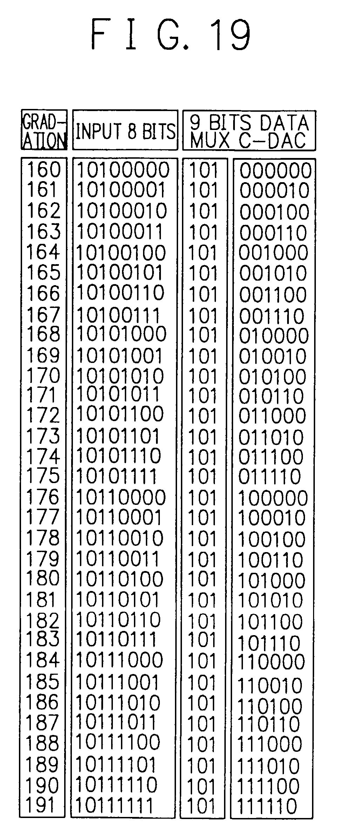

Table 12 (Fig. 19) is a table showing a conversion method of 8 bits to 9 bits in cases where there is equally segmented $V_5$ to $V_6$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

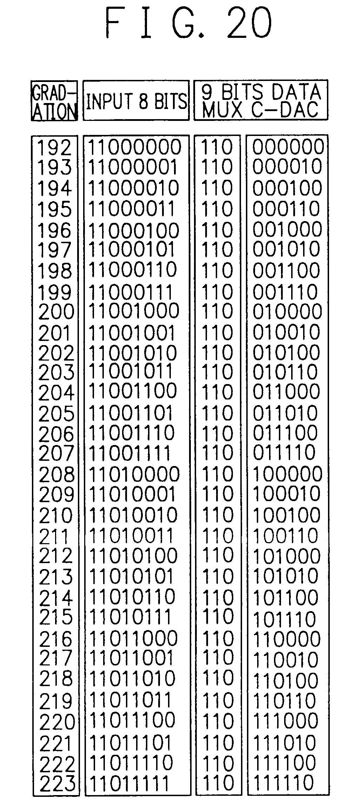

Table 13 (Fig. 20) is a table showing a conversion method of 8 bits to 9 bits in cases where there is equally segmented $V_6$ to $V_7$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

Table 14 (Fig. 21) is a table showing a conversion method of 8 bits to 9 bits in cases where there is equally segmented $V_7$ to $V_8$ therebetween into 32 equi-segmentation. There is judged the high order 3 bits from the high order 3 bits of the input 8 bits in order to input to the multiplexer circuit 4, thus using for the high order 4 bits of the low order 6 bits as they are.

Next, table 1 (Fig. 8) to table 6 (Fig. 13) show that there is equally segmented $V_0$ to $V_1$ therebetween into 16 equi-segmentation, $V_1$ to $V_2$ therebetween into 16 equi-segmentation, $V_2$ to $V_3$ therebetween into 32 equi-segmentation, $V_3$ to $V_4$ therebetween into 64 equi-segmentation, $V_4$ to $V_5$ therebetween into 64 equi-segmentation, $V_5$ to $V_6$ therebetween into 32 equi-segmentation, $V_6$ to $V_7$ therebetween into 16 equi-segmentation, and $V_7$ to $V_8$ therebetween into 16 equi-segmentation.

The conversion method of this case is shown in table 1 (Fig. 8) to table 6 (Fig. 13). The table 1 (Fig. 8) is a table showing a conversion method of 8 bits to 9 bits in the cases where there is segmented equally $V_0$ to $V_1$ therebetween into 16 equi-segmentation, and there is segmented equally $V_1$ to $V_2$ therebetween into 16 equi-segmentation. Firstly, there is judged the high order 3 bits in order to input to the multiplexer circuit 4 from the high order 4 bits of the input 8 bits. When the high order 4 bits are ' 0 0 0 0', there is inputted ' 0 0 0' to the multiplexer 4. When the high order 4 bits are ' 0 0 0 1 ', there is inputted' 0 0 1 ' to the multiplexer circuit 4.

Next, there will be described creation method of the low order 6 bits in order to input to the digital-analog conversion circuit 5. In the case of 16 equi-segmentation, it is proper that the low order 2 bits among the low order 6 bits are ' 0 0 'when the equi-segmentation is 16 equi-segmentation. Consequently, there is used the low order 4 bits of the input 8 bits as the high order 4 bits of the low order 6 bits as they are, furthermore, adding' 0 0 ' to the low order 2 bits to input toward the digital-analog conversion circuit 5.

The table 2 (Fig. 9) is a table showing conversion method of 8 bits to 9 bits in cases where there is segmented equally V2 to V3 therebetween into 32 equi-segmentation. Firstly, there is judged the high order 3 bits in order to input to the multiplexer circuit 4 from the high order 4 bits of the input 8 bits. When the high order 4 bits are ' 0 0 1 0' and' 0 0 1 1 ', there is inputted' 0 1 0' to the multiplexer circuit 4.

Next, there will be described creation method of the low order 6 bits in order to input to the digital-analog conversion circuit 5. When the equi-segmentation is 32 equi-segmentation, it is suitable that low order 1 bit among the low order 6 bits is ' 0 '. Consequently, there is used the low order 5 bits of the input 8 bits as the high order 5 bits of the low order 6 bits as they are, furthermore, there is added '0 ' to the low order 1 bit thereof, thus inputting to the digital-analog conversion circuit 5.

The table 3A (Fig. 10A), and the table 3B (Fig. 10B) are tables showing conversion method of 8 bits to 9 bits in cases where there is segmented equally $V_3$ to $V_4$ therebetween into 64 equi-segmentation. Firstly, there is judged the high order 3 bits in order to input to the multiplexer circuit 4 from the high order 4 bits of the input 8 bits. When the high order 4 bits are '0 1 0 0', ' 0 1 0 1 ', ' 0 1 1 0 ', and ' 0 1 1 1 ', there is inputted ' 0 1 1 ' toward the multiplexer circuit 4.

Next, there will be described a creation method of the low order 6 bits in order to input to the digital-analog conversion circuit 5. When the equi-segmentation is 64 equi-segmentation, there is inputted the low order 6 bits as they are, toward the digital-analog conversion circuit 5.

The table 4A (Fig. 11A), and the table 4B (Fig. 11B) are tables showing conversion method of 8 bits to 9 bits in cases where there is segmented equally $V_4$ to $V_5$ therebetween into 64 equi-segmentation. Firstly, there is judged the high order 3 bits in order to input to the multiplexer circuit 4 from the high order 4 bits of the input 8 bits. When the high order 4 bits are ' 1 0 0 0 ', ' 1 0 0 1 ', ' 1 0 1 0', and ' 1 0 1 1', there is inputted' 1 0 0' toward the multiplexer circuit 4.

Next, there will be described a creation method of the low order 6 bits in order to input to the digital-analog conversion circuit 5. When the equi-segmentation is 64 equi-segmentation, there is inputted the low order 6 bits as they are, toward the digital-analog conversion circuit 5.

The table 5 (Fig. 12) is a table showing a conversion method of 8 bits to 9 bits in cases where there is segmented equally $V_5$ to $V_6$ therebetween into 32 equi-segmentation.

There is judged the high order 3 bits in order to input to the multiplexer circuit 4 from the high order 4 bits of the input 8 bits. When the high order 4 bits are ' 1 1 0 0', and' 1 1 0 1 ', there is inputted' 1 0 1 ' toward the multiplexer circuit 4.

Next, there will be described creation method of the low order 6 bits in order to input to the digital-analog conversion circuit 5. When the equi-segmentation is 32 equi-segmentation, it is suitable that low order 1 bit among the low order 6 bits is ' 0 '. Consequently, there is used the low order 5 bits of the input 8 bits as the high order 5 bits of the low order 6 bits as they are, furthermore, there is added '0' to the low order 1 bit thereof, thus inputting to the digital-analog conversion circuit 5.

The table 6 (Fig. 13) is a table showing a conversion method of 8 bits to 9 bits in the cases where there is segmented equally $V_6$ to $V_7$ therebetween into 16 equi-segmentation, and there is segmented equally $V_7$ to $V_8$ therebetween into 16 equi-segmentation. Firstly, there is judged the high order 3 bits in order to input to the multiplexer circuit 4 from the high order 4 bits of the input 8 bits. When the high order 4 bits are ' 1 1 1 0', there is inputted ' 1 1 0' to the multiplexer 4. When the high order 4 bits are ' 1 1 1 1 ', there is inputted' 1 1 1 ' to the multiplexer circuit 4.

Next, there will be described creation method of the low order 6 bits in order to input to the digital-analog conversion circuit 5. In the case of 16 equi-segmentation, it is proper that the low order 2 bits among the low order 6 bits are ' 0 0 ' when the equi-segmentation is 16 equi-segmentation. Consequently, there is used the low order 4 bits of the input 8 bits as the high order 4 bits of the low order 6 bits as they are, furthermore, adding' 0 0 ' to the low order 2 bits to input toward the digital-analog circuit 5.

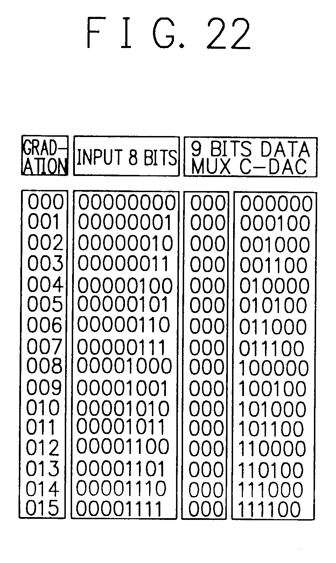

Next, it is the third case of the second embodiment in which table 15 (Fig. 22) to table 22 (Fig. 29) show that there is equally segmented $V_0$ to $V_1$ therebetween into 16 equi-segmentation, $V_1$ to $V_2$ therebetween into 32 equi-segmentation, $V_2$ to $V_3$ therebetween into 32 equi-segmentation, $V_3$ to $V_4$ therebetween into 64 equi-segmentation, $V_4$ to $V_5$ therebetween into 32 equi-segmentation, $V_5$ to $V_6$ therebetween into 32 equi-segmentation, $V_6$ to $V_7$ therebe-

tween into 32 equi-segmentation, and $V_7$ to $V_8$ therebetween into 16 equi-segmentation.

There is described conversion method of the third case of the second embodiment referring to table 15 (Fig. 22) to table 22 (Fig. 29) as follows:

Table 15 (Fig. 22) is a table showing conversion method of 8 bits to 9 bits in cases where there is equally segmented $V_0$ to $V_1$ therebetween into 16 equi-segmentation. Firstly, there is judged the high order 3 bits in order to input to the multiplexer circuit 4 from the high order 4 bits of the input 8 bits. When the high order 4 bits are ' 0 0 0 0 ', there is inputted ' 0 0 0' to the multiplexer 4.

Next, there will be described creation method of the low order 6 bits in order to input to the digital-analog conversion circuit 5. In the case of 16 equi-segmentation, it is proper that the low order 2 bits among the low order 6 bits are ' 0 0' when the equi-segmentation is 16 equi-segmentation. Consequently, there is used the low order 4 bits of the input 8 bits as the high order 4 bits of the low order 6 bits as they are, furthermore, adding ' 0 0 ' to the low order 2 bits to input toward the digital-analog conversion circuit 5.

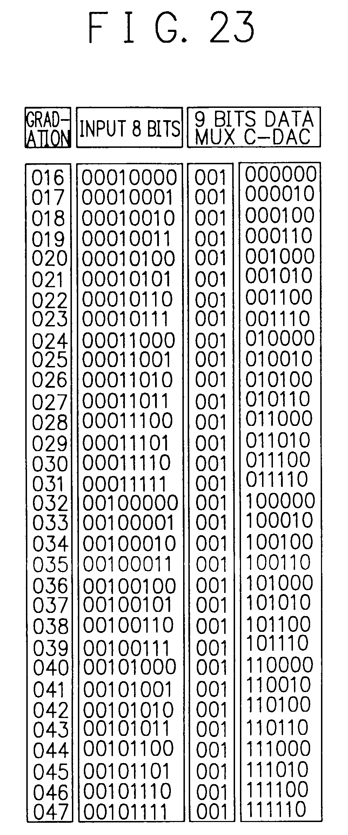

Table 16 (Fig. 23) is a table showing conversion method of 8 bits to 9 bits in cases where there is equally segmented $V_1$ to $V_2$ therebetween into 32 equi-segmentation. Firstly, there is judged the high order 3 bits in order to input to the multiplexer circuit 4 from the high order 4 bits of the input 8 bits. When the high order 4 bits are ' 0 0 0 1 ' and '0 0 1 0 ', there is inputted ' 0 0 1 ' to the multiplexer circuit 4.

Next, there will be described the creation method of the low order 6 bits in order to input to the digital-analog conversion circuit 5. In the 32 equi-segmentation of this case, there is referred to 8 bits data which is obtained in such a way that 16 is subtracted from the input 8 bits data. For instance, when the input data is of the thirty eighth (38-th) gradation of '0 0 1 0 0 1 1 0', there is subtracted 16 from this data to be converted into '0 0 0 0 1 0 1 1 0 '. There is used the low order 5 bits thereof after conversion by way of the high order 5 bits of the low order 6 bits as they are. Furthermore, ' 0 ' is added to remaining low order 1 bit, thus inputting to the digital-analog conversion circuit 5.

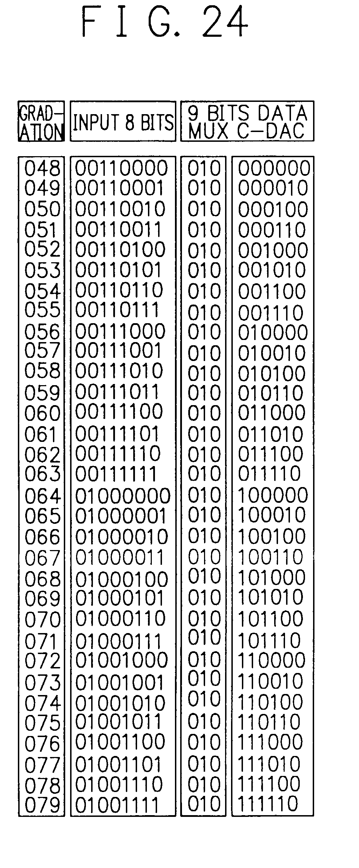

Table 17 (Fig. 24) is a table showing a conversion method of 8 bits to 9 bits in cases where there is equally segmented $V_2$ to $V_3$ therebetween into 32 equi-segmentation. Firstly, there is judged the high order 3 bits in order to input to the multiplexer circuit 4 from the high order 4 bits of the input 8 bits. When the high order 4 bits are ' 0 0 1 1 ' and '0 1 0 0 ', there is inputted '0 1 0' to the multiplexer circuit 4.

Next, there will be described the creation method of the low order 6 bits in order to input to the digital-analog conversion circuit 5. In the 32 equi-segmentation of this case, there is referred to 8 bits data which is obtained in such a way that 16 is subtracted from the input 8 bits data. There is used the low order 5 bits thereof after conversion by way of the high order 5 bits of the low order 6 bits as they are. Furthermore, ' 0' is added to remaining low order 1 bit, thus inputting to the digital-analog conversion circuit 5.

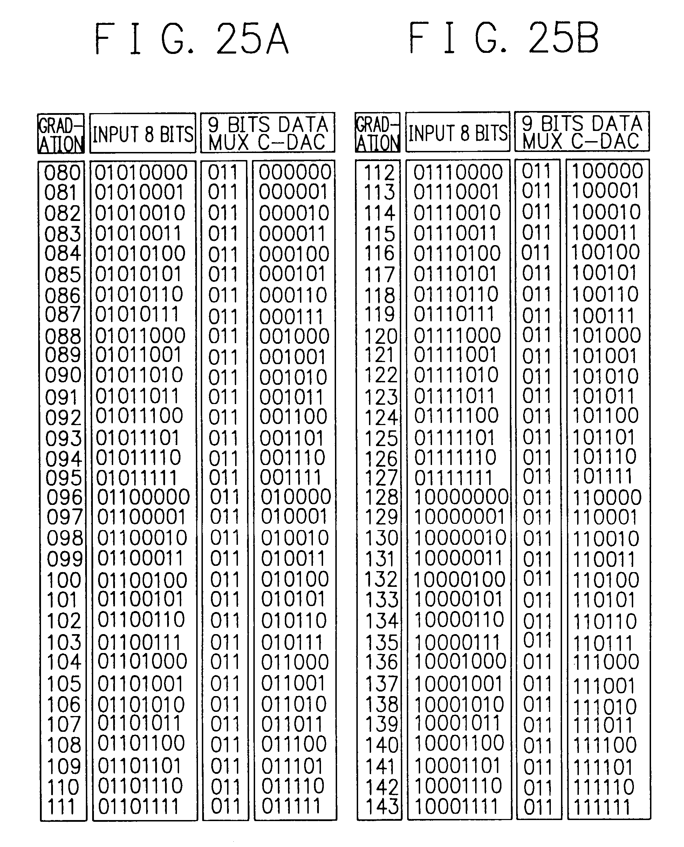

The table 18A (Fig. 25A), and the table 18B (Fig. 25B) are tables showing conversion method of 8 bits to 9 bits in cases where there is segmented equally $V_2$ to $V_3$ therebetween into 64 equi-segmentation. Firstly, there is judged the high order 3 bits from the high order 4 bits of the input 8 bits in order to input to the multiplexer circuit 4. When the high order 4 bits are '0 1 0 1 ', '0 1 1 0', '0 1 1 1 ', and '1 0 0 0', there is inputted'0 1 1 ' toward the multiplexer circuit 4.

Next, there will be described the creation method of the low order 6 bits in order to input to the digital-analog conversion circuit 5. In the 64 equi-segmentation of this case, there is referred to 8 bits data which is obtained in such a way that 16 is subtracted from the input 8 bits data. There is inputted the low order 6 bits after conversion to the digital- analog conversion circuit 5 as they are.

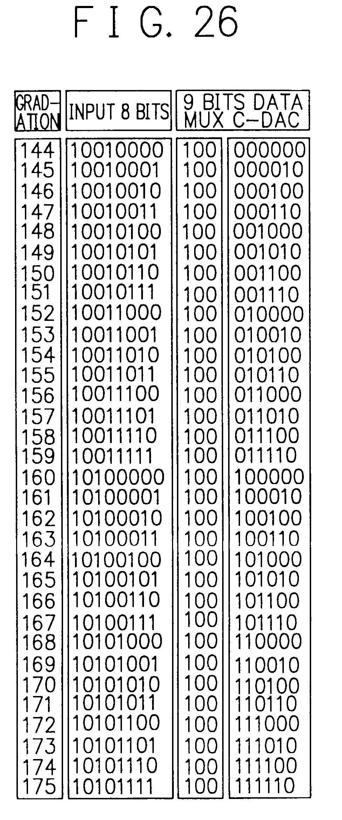

The table 19 (Fig. 26) is a table showing a conversion method of 8 bits to 9 bits in cases where there is segmented equally $V_4$ to $V_5$ therebetween into 32 equi-segmentation. There is judged the high order 3 bits in order to input to the multiplexer circuit 4 from the high order 4 bits of the input 8 bits. When the high order 4 bits are ' 1 0 0 1 ', and ' 1 0 1 0 ', there is inputted ' 1 0 0 ' toward the multiplexer circuit 4.

Next, there will be described the creation method of the low order 6 bits in order to input to the digital-analog conversion circuit 5. In the 32 equi-segmentation of this case, there is referred to 8 bits data which is obtained in such a way that 16 is subtracted from the input 8 bits data. There is used the low order 5 bits thereof after conversion by way of the high order 5 bits of the low order 6 bits as they are. Furthermore, ' 0' is added to remaining low order 1 bit, thus inputting to the digital-analog conversion circuit 5.

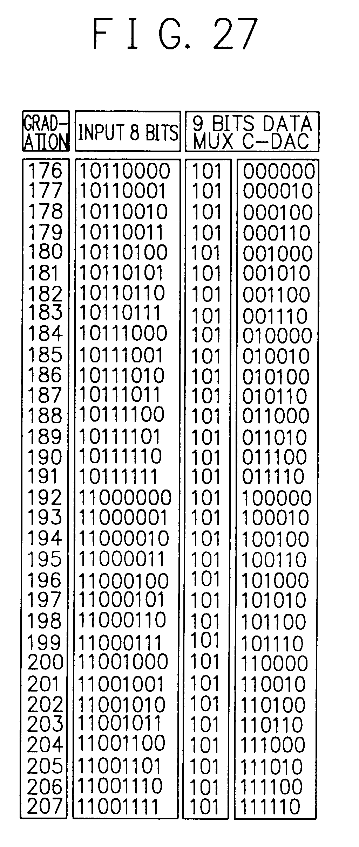

The table 20 (Fig. 27) is a table showing a conversion method of 8 bits to 9 bits in cases where there is segmented equally $V_5$ to $V_6$ therebetween into 32 equi-segmentation. There is judged the high order 3 bits in order to input to the multiplexer circuit 4 from the high order 4 bits of the input 8 bits. When the high order 4 bits are ' 1 0 1 1 ', and ' 1 1 0 0', there is inputted' 1 0 1 ' toward the multiplexer circuit 4.

Next, there will be described the creation method of the low order 6 bits in order to input to the digital-analog conversion circuit 5. In the 32 equi-segmentation of this case, there is referred to 8 bits data which is obtained in such a way that 16 is subtracted from the input 8 bits data. There is used the low order 5 bits thereof after conversion by way of the high order 5 bits of the low order 6 bits as they are. Furthermore, ' 0' is added to remaining low order 1 bit, thus inputting to the digital-analog conversion circuit 5.

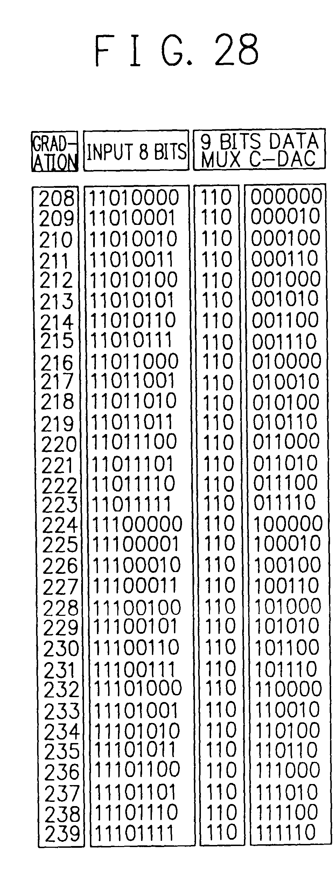

The table 21 (Fig. 28) is a table showing a conversion method of 8 bits to 9 bits in cases where there is segmented equally $V_6$ to $V_7$ therebetween into 32 equi-segmentation. There is judged the high order 3 bits in order to input to the multiplexer circuit 4 from the high order 4 bits of the input 8 bits. When the high order 4 bits are ' 1 1 0 1 and '1 1 1 0 ', there is inputted' 1 1 0' toward the multiplexer circuit 4.

Next, there will be described the creation method of the low order 6 bits in order to input to the digital-analog conversion circuit 5. In the 32 equi-segmentation of this case, there is referred to 8 bits data which is obtained in such a way that 16 is subtracted from the input 8 bits data. There is used the low order 5 bits thereof after conversion by way of the high order 5 bits of the low order 6 bits as they are. Furthermore, '0' is added to remaining low order 1 bit, thus inputting to the digital-analog conversion circuit 5.

Table 22 (Fig. 29) is a table showing conversion method of 8 bits to 9 bits in cases where there is equally segmented $V_7$ to $V_8$ therebetween into 16 equi-segmentation. Firstly, there is judged the high order 3 bits in order to input to the multiplexer circuit 4 from the high order 4 bits of the input 8 bits. When the high order 4 bits are' 1 1 1 1', there is inputted '1 1 1' to the multiplexer 4.

Next, there will be described creation method of the low order 6 bits in order to input to the digital-analog conversion circuit 5. In the case of 16 equi-segmentation, it is proper that the low order 2 bits among the low order 6 bits are '0 0' when the equi-segmentation is 16 equi-segmentation. Consequently, there is used the low order 4 bits of the input 8 bits as the high order 4 bits of the low order 6 bits as they are, furthermore, adding '0 0' to the low order 2 bits to input toward the digital-analog conversion circuit 5.

As described above, according to the present second embodiment, since a plurality of N-bit-F-bit conversion circuits are used, there is the effect that it is capable of being switched the segmentation method.

As described above, according to the present invention, it enables kinds of segmentation to be increased by increasing bit number at the inside of the C-DAC. In the conventional C-DAC, it only enables two $\gamma$ correction voltages therebetween to be segmented into fixed number of equi-segmentation regardless of large-ness of the $\gamma$ correction voltage. For that reason, according to the present invention, it is capable of being approached the output voltage of the C-DAC toward the ideal $\gamma$ curve of the liquid crystal display panel, while causing number of segmentation of the $\gamma$ correction volt-age to be variable in answer to largeness of the correction voltage such as 8 equi-segmentation, 16 equi-segmentation, 32 equi-segmentation, ···, and so forth.

While preferred embodiments of the invention have been described using specific terms, such description is for illustrative purpose only, and it is to be understood that changes and variations may be made without departing from the spirit or scope of the following claims.

## Claims

1. A liquid crystal driving circuit which is provided with a capacitance array type digital-analog conversion circuit selecting two voltages adjacent to each other out of a plurality of $\gamma$ correction voltages inputted from an outer section in accordance with high order P bits of input data of N bits to be displayed, and said digital-analog conversion circuit generates $2^N$ pieces of voltages from said input data of N bits by segmenting equally two $\gamma$ correction voltages therebetween selected previously into the number in answer to remaining low order bit of said input data to be displayed, thus outputting one of $2^N$ pieces of voltages by way of a liquid crystal drive voltage, comprising:

   a bit conversion circuit for amplifying bit number in terms of bit number of said input data to be displayed to F bits which is larger than N bits, so that there can be equally segmented two $\gamma$ correction voltages therebetween selected previously into $2^{F-P}$ equi-segmentation which is larger than $2^{N-P}$.

2. A liquid crystal driving circuit comprising:

   a data buffer circuit with N bits provided with input terminal of N bits and output terminal of N bits for performing data transfer of input data with N bits to be displayed, which is inputted to said input terminal toward circuit of next stage connected to said output terminal;
   a bit conversion circuit provided with input terminal of N bits and output terminal of F bits for performing bit number amplification of bit number of N bit data in terms of bit number of data with N bits outputted by said data buffer circuit to F bits which is larger than N bits while connecting to the output terminal of said data buffer circuit;
   a data latch circuit provided with input terminal of F bits and output terminal of F bits for maintaining data of F bits which said bit conversion circuit outputs while connecting to the output terminal of said bit conversion circuit;
   a multiplexer which is connected both to high order P bits data of output bit of said data latch circuit and outer $\gamma$ correction power source device outputting a plurality of $\gamma$ correction voltage for selecting two voltages adjacent to each other concerning voltage value out of said plurality of $\gamma$ correction voltages which said $\gamma$ correction power source device outputs while referring to the high order P bit data transferred from said data latch circuit, thus transferring analog voltage selected previously to a next stage; and
   a digital-analog conversion circuit of capacitor array type with G bits taking two analog voltage signals outputted from said multiplexer circuit and low order G bits data (G=F-P) of F bits output outputted by said data latch circuit as input, for segmenting two analog voltage signals outputted from said multiplexer circuit equally, and for outputting liquid crystal drive voltage value in answer to input data out of voltage values segmented equally depending on the input data from said data latch circuit,
   wherein there is established G as being G = F-P > N-P, thereby, it enables two $\gamma$ correction voltages therebetween selected by said multiplexer circuit to be segmented equally into the number which is larger than $2^{N-P}$.

3. A liquid crystal driving circuit as claimed in claim 1, wherein it enables number of segmentation of said selected two $\gamma$ correction voltages therebetween to be selected in answer to the value of segmented $\gamma$ correction voltages.

4. A liquid crystal driving circuit as claimed in claim 2, wherein it enables number of segmentation of said selected two $\gamma$ correction voltages therebetween to be selected in answer to the value of segmented $\gamma$ correction voltages.

5. A liquid crystal driving circuit as claimed in claim 2, wherein there are provided a plurality of bit conversion circuits in parallel, whose data formalities are different from one another, between said data buffer circuit and said data latch circuit, and means for connecting one bit conversion circuit both to said data buffer circuit and said data latch circuit while selecting one of said plurality of bit conversion circuits depending on a signal from an outer section, in which it enables a data formality inputting to said data latch circuit to be selected out of plural kinds of data formalities.

6. A liquid crystal driving circuit as claimed in any one of claim 1 to claim 5, wherein an output polarity is to be variable alternately.

# F I G. 1
## PRIOR ART

DATA BUFFER
CIRCUIT
70

DBF

DATA LATCH
CIRCUIT
80

LAT

DA CONVERSION
CIRCUIT
90

DAC

DRIVE CIRCUIT
100

200

LIQUID CRYSTAL
DISPLAY PANEL

# F I G. 2
## PRIOR ART

LATCH GROUP
81

RESISTOR
91

OPERATIONAL
AMPLIFIER
93

R-DAC
90R

LAT

LAT

LAT

LAT

SWITCH GROUP
92

# F I G. 3
## PRIOR ART

OUTER INPUT τ CORRECTION VOLTAGE 97

CAPACITOR GROUP 94

C=UNIT CAPACITOR

LATCH GROUP 81

96

MUX

LAT

CONT

LAT

LAT

LAT

2C
C
C
4C
4C C
2C
C

OPERATIONAL AMPLIFIER 95

C-DAC 90C

98

EP 0 940 798 A1

# F I G. 4
## PRIOR ART

# F I G. 5

# F I G. 6

# F I G. 7

# F I G. 8

| GRAD-ATION | INPUT 8 BITS | 9 BITS DATA MUX C-DAC | |
|---|---|---|---|
| 000 | 00000000 | 000 | 000000 |
| 001 | 00000001 | 000 | 000100 |
| 002 | 00000010 | 000 | 001000 |
| 003 | 00000011 | 000 | 001100 |
| 004 | 00000100 | 000 | 010000 |
| 005 | 00000101 | 000 | 010100 |
| 006 | 00000110 | 000 | 011000 |
| 007 | 00000111 | 000 | 011100 |
| 008 | 00001000 | 000 | 100000 |
| 009 | 00001001 | 000 | 100100 |
| 010 | 00001010 | 000 | 101000 |
| 011 | 00001011 | 000 | 101100 |
| 012 | 00001100 | 000 | 110000 |
| 013 | 00001101 | 000 | 110100 |
| 014 | 00001110 | 000 | 111000 |
| 015 | 00001111 | 000 | 111100 |
| 016 | 00010000 | 001 | 000000 |
| 017 | 00010001 | 001 | 000100 |
| 018 | 00010010 | 001 | 001000 |
| 019 | 00010011 | 001 | 001100 |
| 020 | 00010100 | 001 | 010000 |
| 021 | 00010101 | 001 | 010100 |
| 022 | 00010110 | 001 | 011000 |
| 023 | 00010111 | 001 | 011100 |
| 024 | 00011000 | 001 | 100000 |
| 025 | 00011001 | 001 | 100100 |
| 026 | 00011010 | 001 | 101000 |
| 027 | 00011011 | 001 | 101100 |
| 028 | 00011100 | 001 | 110000 |
| 029 | 00011101 | 001 | 110100 |
| 030 | 00011110 | 001 | 111000 |
| 031 | 00011111 | 001 | 111100 |

# F I G. 9

| GRAD-ATION | INPUT 8 BITS | 9 BITS DATA MUX C-DAC | |
|---|---|---|---|
| 032 | 00100000 | 010 | 000000 |
| 033 | 00100001 | 010 | 000010 |
| 034 | 00100010 | 010 | 000100 |
| 035 | 00100011 | 010 | 000110 |
| 036 | 00100100 | 010 | 001000 |
| 037 | 00100101 | 010 | 001010 |
| 038 | 00100110 | 010 | 001100 |
| 039 | 00100111 | 010 | 001110 |
| 040 | 00101000 | 010 | 010000 |
| 041 | 00101001 | 010 | 010010 |
| 042 | 00101010 | 010 | 010100 |
| 043 | 00101011 | 010 | 010110 |
| 044 | 00101100 | 010 | 011000 |
| 045 | 00101101 | 010 | 011010 |
| 046 | 00101110 | 010 | 011100 |
| 047 | 00101111 | 010 | 011110 |
| 048 | 00110000 | 010 | 100000 |
| 049 | 00110001 | 010 | 100010 |
| 050 | 00110010 | 010 | 100100 |
| 051 | 00110011 | 010 | 100110 |
| 052 | 00110100 | 010 | 101000 |
| 053 | 00110101 | 010 | 101010 |
| 054 | 00110110 | 010 | 101100 |
| 055 | 00110111 | 010 | 101110 |
| 056 | 00111000 | 010 | 110000 |
| 057 | 00111001 | 010 | 110010 |
| 058 | 00111010 | 010 | 110100 |
| 059 | 00111011 | 010 | 110110 |
| 060 | 00111100 | 010 | 111000 |
| 061 | 00111101 | 010 | 111010 |
| 062 | 00111110 | 010 | 111100 |
| 063 | 00111111 | 010 | 111110 |

# F I G. 10A          F I G. 10B

| GRAD-ATION | INPUT 8 BITS | 9 BITS DATA MUX C-DAC | |
|---|---|---|---|
| 064 | 01000000 | 011 | 000000 |
| 065 | 01000001 | 011 | 000001 |
| 066 | 01000010 | 011 | 000010 |
| 067 | 01000011 | 011 | 000011 |
| 068 | 01000100 | 011 | 000100 |
| 069 | 01000101 | 011 | 000101 |
| 070 | 01000110 | 011 | 000110 |
| 071 | 01000111 | 011 | 000111 |
| 072 | 01001000 | 011 | 001000 |
| 073 | 01001001 | 011 | 001001 |
| 074 | 01001010 | 011 | 001010 |
| 075 | 01001011 | 011 | 001011 |
| 076 | 01001100 | 011 | 001100 |
| 077 | 00001101 | 011 | 001101 |
| 078 | 00001110 | 011 | 001110 |
| 079 | 00001111 | 011 | 011111 |
| 080 | 01010000 | 011 | 010000 |
| 081 | 01010001 | 011 | 010001 |
| 082 | 01010010 | 011 | 010010 |
| 083 | 01010011 | 011 | 010011 |
| 084 | 01010100 | 011 | 010100 |
| 085 | 01010101 | 011 | 010101 |
| 086 | 01010110 | 011 | 010110 |
| 087 | 01010111 | 011 | 010111 |
| 088 | 01011000 | 011 | 011000 |
| 089 | 01011001 | 011 | 011001 |
| 090 | 01011010 | 011 | 011010 |
| 091 | 01011011 | 011 | 011011 |
| 092 | 01011100 | 011 | 011100 |
| 093 | 01011101 | 011 | 011101 |
| 094 | 01011110 | 011 | 011110 |
| 095 | 01011111 | 011 | 011111 |

| GRAD-ATION | INPUT 8 BITS | 9 BITS DATA MUX C-DAC | |
|---|---|---|---|
| 096 | 01100000 | 011 | 100000 |
| 097 | 01100001 | 011 | 100001 |
| 098 | 01100010 | 011 | 100010 |
| 099 | 01100011 | 011 | 100011 |
| 100 | 01100100 | 011 | 100100 |
| 101 | 01100101 | 011 | 100101 |
| 102 | 01100110 | 011 | 100110 |
| 103 | 01100111 | 011 | 100111 |
| 104 | 01101000 | 011 | 101000 |
| 105 | 01101001 | 011 | 101001 |
| 106 | 01101010 | 011 | 101010 |
| 107 | 01101011 | 011 | 101011 |
| 108 | 01101100 | 011 | 101100 |
| 109 | 01101101 | 011 | 101101 |
| 110 | 01101110 | 011 | 101110 |
| 111 | 01101111 | 011 | 101111 |
| 112 | 01110000 | 011 | 110000 |
| 113 | 01110001 | 011 | 110001 |
| 114 | 01110010 | 011 | 110010 |
| 115 | 01110011 | 011 | 110011 |
| 116 | 01110100 | 011 | 110100 |
| 117 | 01110101 | 011 | 110101 |
| 118 | 01110110 | 011 | 110110 |
| 119 | 01110111 | 011 | 110111 |
| 120 | 01111000 | 011 | 111000 |
| 121 | 01111001 | 011 | 111001 |
| 122 | 01111010 | 011 | 111010 |
| 123 | 01111011 | 011 | 111011 |
| 124 | 01111100 | 011 | 111100 |
| 125 | 01111101 | 011 | 111101 |
| 126 | 01111110 | 011 | 111110 |
| 127 | 01111111 | 011 | 111111 |

# F I G. 11A

| GRAD-ATION | INPUT 8 BITS | 9 BITS DATA | |
|---|---|---|---|
| | | MUX | C-DAC |
| 128 | 10000000 | 100 | 000000 |
| 129 | 10000001 | 100 | 000001 |
| 130 | 10000010 | 100 | 000010 |
| 131 | 10000011 | 100 | 000011 |
| 132 | 10000100 | 100 | 000100 |
| 133 | 10000101 | 100 | 000101 |
| 134 | 10000110 | 100 | 000110 |
| 135 | 10000111 | 100 | 000111 |
| 136 | 10001000 | 100 | 001000 |
| 137 | 10001001 | 100 | 001001 |
| 138 | 10001010 | 100 | 001010 |
| 139 | 10001011 | 100 | 001011 |
| 140 | 10001100 | 100 | 001100 |
| 141 | 10001101 | 100 | 001101 |
| 142 | 10001110 | 100 | 001110 |
| 143 | 10001111 | 100 | 001111 |
| 144 | 10010000 | 100 | 010000 |
| 145 | 10010001 | 100 | 010001 |
| 146 | 10010010 | 100 | 010010 |
| 147 | 10010011 | 100 | 010011 |
| 148 | 10010100 | 100 | 010100 |
| 149 | 10010101 | 100 | 010101 |
| 150 | 10010110 | 100 | 010110 |
| 151 | 10010111 | 100 | 010111 |
| 152 | 10011000 | 100 | 011000 |
| 153 | 10011001 | 100 | 011001 |
| 154 | 10011010 | 100 | 011010 |
| 155 | 10011011 | 100 | 011011 |
| 156 | 10011100 | 100 | 011100 |
| 157 | 10011101 | 100 | 011101 |
| 158 | 10011110 | 100 | 011110 |
| 159 | 10011111 | 011 | 011111 |

# F I G. 11B

| GRAD-ATION | INPUT 8 BITS | 9 BITS DATA | |
|---|---|---|---|
| | | MUX | C-DAC |
| 160 | 10100000 | 100 | 100000 |
| 161 | 10100001 | 100 | 100001 |
| 162 | 10100010 | 100 | 100010 |
| 163 | 10100011 | 100 | 100011 |
| 164 | 10100100 | 100 | 100100 |
| 165 | 10100101 | 100 | 100101 |
| 166 | 10100110 | 100 | 100110 |
| 167 | 10100111 | 100 | 100111 |
| 168 | 10101000 | 100 | 101000 |
| 169 | 10101001 | 100 | 101001 |
| 170 | 10101010 | 100 | 101010 |
| 171 | 10101011 | 100 | 101011 |
| 172 | 10101100 | 100 | 101100 |
| 173 | 10101101 | 100 | 101101 |
| 174 | 10101110 | 100 | 101110 |
| 175 | 10101111 | 100 | 101111 |
| 176 | 10110000 | 100 | 110000 |
| 177 | 10110001 | 100 | 110001 |
| 178 | 10110010 | 100 | 110010 |
| 179 | 10110011 | 100 | 110011 |
| 180 | 10110100 | 100 | 110100 |
| 181 | 10110101 | 100 | 110101 |
| 182 | 10110110 | 100 | 110110 |
| 183 | 10110111 | 100 | 110111 |
| 184 | 10111000 | 100 | 111000 |
| 185 | 10111001 | 100 | 111001 |
| 186 | 10111010 | 100 | 111010 |
| 187 | 10111011 | 100 | 111011 |
| 188 | 10111100 | 100 | 111100 |
| 189 | 10111101 | 100 | 111101 |
| 190 | 10111110 | 100 | 111110 |
| 191 | 10111111 | 100 | 111111 |

# F I G. 12

| GRAD-ATION | INPUT 8 BITS | 9 BITS DATA MUX C-DAC | |
|---|---|---|---|
| 192 | 11000000 | 101 | 000000 |
| 193 | 11000001 | 101 | 000010 |
| 194 | 11000010 | 101 | 000100 |
| 195 | 11000011 | 101 | 000110 |
| 196 | 11000100 | 101 | 001000 |
| 197 | 11000101 | 101 | 001010 |
| 198 | 11000110 | 101 | 001100 |
| 199 | 11000111 | 101 | 001110 |
| 200 | 11001000 | 101 | 010000 |
| 201 | 11001001 | 101 | 010010 |
| 202 | 11001010 | 101 | 010100 |
| 203 | 11001011 | 101 | 010110 |
| 204 | 11001100 | 101 | 011000 |
| 205 | 11001101 | 101 | 011010 |
| 206 | 11001110 | 101 | 011100 |
| 207 | 11001111 | 101 | 011110 |
| 208 | 11010000 | 101 | 100000 |
| 209 | 11010001 | 101 | 100010 |
| 210 | 11010010 | 101 | 100100 |
| 211 | 11010011 | 101 | 100110 |
| 212 | 11010100 | 101 | 101000 |
| 213 | 11010101 | 101 | 101010 |
| 214 | 11010110 | 101 | 101100 |
| 215 | 11010111 | 101 | 101110 |
| 216 | 11011000 | 101 | 110000 |
| 217 | 11011001 | 101 | 110010 |
| 218 | 11011010 | 101 | 110100 |
| 219 | 11011011 | 101 | 110110 |
| 220 | 11011100 | 101 | 111000 |
| 221 | 11011101 | 101 | 111010 |
| 222 | 11011110 | 101 | 111100 |
| 223 | 11011111 | 101 | 111110 |

# F I G. 13

| GRAD- ATION | INPUT 8 BITS | 9 BITS DATA MUX C-DAC | |
|---|---|---|---|
| 224 | 11100000 | 110 | 000000 |
| 225 | 11100001 | 110 | 000100 |
| 226 | 11100010 | 110 | 001000 |
| 227 | 11100011 | 110 | 001100 |
| 228 | 11100100 | 110 | 010000 |
| 229 | 11100101 | 110 | 010100 |
| 230 | 11100110 | 110 | 011000 |
| 231 | 11100111 | 110 | 011100 |
| 232 | 11101000 | 110 | 100000 |
| 233 | 11101001 | 110 | 100100 |
| 234 | 11101010 | 110 | 101000 |
| 235 | 11101011 | 110 | 101100 |
| 236 | 11101100 | 110 | 110000 |
| 237 | 11101101 | 110 | 110100 |
| 238 | 11101110 | 110 | 111000 |
| 239 | 11101111 | 110 | 111100 |
| 240 | 11110000 | 111 | 000000 |
| 241 | 11110001 | 111 | 000100 |
| 242 | 11110010 | 111 | 001000 |
| 243 | 11110011 | 111 | 001100 |
| 244 | 11110100 | 111 | 010000 |
| 245 | 11110101 | 111 | 010100 |
| 246 | 11110110 | 111 | 011000 |
| 247 | 11110111 | 111 | 011100 |
| 248 | 11111000 | 111 | 100000 |
| 249 | 11111001 | 111 | 100100 |
| 250 | 11111010 | 111 | 101000 |
| 251 | 11111011 | 111 | 101100 |
| 252 | 11111100 | 111 | 110000 |
| 253 | 11111101 | 111 | 110100 |
| 254 | 11111110 | 111 | 111000 |
| 255 | 11111111 | 111 | 111100 |

# F I G. 14

| GRAD-ATION | INPUT 8 BITS | 9 BITS DATA MUX | C-DAC |
|---|---|---|---|
| 000 | 00000000 | 000 | 000000 |
| 001 | 00000001 | 000 | 000010 |
| 002 | 00000010 | 000 | 000100 |
| 003 | 00000011 | 000 | 000110 |
| 004 | 00000100 | 000 | 001000 |
| 005 | 00000101 | 000 | 001010 |
| 006 | 00000110 | 000 | 001100 |
| 007 | 00000111 | 000 | 001110 |
| 008 | 00001000 | 000 | 010000 |
| 009 | 00001001 | 000 | 010010 |
| 010 | 00001010 | 000 | 010100 |
| 011 | 00001011 | 000 | 010110 |
| 012 | 00001100 | 000 | 011000 |
| 013 | 00001101 | 000 | 011010 |
| 014 | 00001110 | 000 | 011100 |
| 015 | 00001111 | 000 | 011110 |
| 016 | 00010000 | 000 | 100000 |
| 017 | 00010001 | 000 | 100010 |
| 018 | 00010010 | 000 | 100100 |
| 019 | 00010011 | 000 | 100110 |
| 020 | 00010100 | 000 | 101000 |
| 021 | 00010101 | 000 | 101010 |
| 022 | 00010110 | 000 | 101100 |
| 023 | 00010111 | 000 | 101110 |
| 024 | 00011000 | 000 | 110000 |
| 025 | 00011001 | 000 | 110010 |
| 026 | 00011010 | 000 | 110100 |
| 027 | 00011011 | 000 | 110110 |
| 028 | 00011100 | 000 | 111000 |
| 029 | 00011101 | 000 | 111010 |
| 030 | 00011110 | 000 | 111100 |
| 031 | 00011111 | 000 | 111110 |

# F I G. 15

| GRAD-ATION | INPUT 8 BITS | 9 BITS DATA MUX C-DAC | |
|---|---|---|---|
| 032 | 00100000 | 001 | 000000 |
| 033 | 00100001 | 001 | 000010 |
| 034 | 00100010 | 001 | 000100 |
| 035 | 00100011 | 001 | 000110 |
| 036 | 00100100 | 001 | 001000 |
| 037 | 00100101 | 001 | 001010 |
| 038 | 00100110 | 001 | 001100 |
| 039 | 00100111 | 001 | 001110 |
| 040 | 00101000 | 001 | 010000 |
| 041 | 00101001 | 001 | 010010 |
| 042 | 00101010 | 001 | 010100 |
| 043 | 00101011 | 001 | 010110 |
| 044 | 00101100 | 001 | 011000 |
| 045 | 00101101 | 001 | 011010 |
| 046 | 00101110 | 001 | 011100 |
| 047 | 00101111 | 001 | 011110 |
| 048 | 00110000 | 001 | 100000 |
| 049 | 00110001 | 001 | 100010 |
| 050 | 00110010 | 001 | 100100 |
| 051 | 00110011 | 001 | 100110 |
| 052 | 00110100 | 001 | 101000 |
| 053 | 00110101 | 001 | 101010 |
| 054 | 00110110 | 001 | 101100 |
| 055 | 00110111 | 001 | 101110 |
| 056 | 00111000 | 001 | 110000 |
| 057 | 00111001 | 001 | 110010 |
| 058 | 00111010 | 001 | 110100 |
| 059 | 00111011 | 001 | 110110 |
| 060 | 00111100 | 001 | 111000 |
| 061 | 00111101 | 001 | 111010 |
| 062 | 00111110 | 001 | 111100 |
| 063 | 00111111 | 001 | 111110 |

# F I G. 16

| GRAD-ATION | INPUT 8 BITS | 9 BITS DATA MUX C-DAC | |
|---|---|---|---|
| 064 | 01000000 | 010 | 000000 |
| 065 | 01000001 | 010 | 000010 |
| 066 | 01000010 | 010 | 000100 |
| 067 | 01000011 | 010 | 000110 |
| 068 | 01000100 | 010 | 001000 |
| 069 | 01000101 | 010 | 001010 |
| 070 | 01000110 | 010 | 001100 |
| 071 | 01000111 | 010 | 001110 |
| 072 | 01001000 | 010 | 010000 |
| 073 | 01001001 | 010 | 010010 |
| 074 | 01001010 | 010 | 010100 |
| 075 | 01001011 | 010 | 010110 |
| 076 | 01001100 | 010 | 011000 |
| 077 | 01001101 | 010 | 011010 |
| 078 | 01001110 | 010 | 011100 |
| 079 | 01001111 | 010 | 011110 |
| 080 | 01010000 | 010 | 100000 |
| 081 | 01010001 | 010 | 100010 |
| 082 | 01010010 | 010 | 100100 |
| 083 | 01010011 | 010 | 100110 |
| 084 | 01010100 | 010 | 101000 |
| 085 | 01010101 | 010 | 101010 |
| 086 | 01010110 | 010 | 101100 |
| 087 | 01010111 | 010 | 101110 |
| 088 | 01011000 | 010 | 110000 |
| 089 | 01011001 | 010 | 110010 |
| 090 | 01011010 | 010 | 110100 |
| 091 | 01011011 | 010 | 110110 |
| 092 | 01011100 | 010 | 111000 |
| 093 | 01011101 | 010 | 111010 |
| 094 | 01011110 | 010 | 111100 |
| 095 | 01011111 | 010 | 111110 |

# F I G. 17

| GRAD-ATION | INPUT 8 BITS | 9 BITS DATA MUX C-DAC | |
|---|---|---|---|
| 096 | 01100000 | 011 | 000000 |
| 097 | 01100001 | 011 | 000010 |
| 098 | 01100010 | 011 | 000100 |
| 099 | 01100011 | 011 | 000110 |
| 100 | 01100100 | 011 | 001000 |
| 101 | 01100101 | 011 | 001010 |
| 102 | 01100110 | 011 | 001100 |
| 103 | 01100111 | 011 | 001110 |
| 104 | 01101000 | 011 | 010000 |
| 105 | 01101001 | 011 | 010010 |
| 106 | 01101010 | 011 | 010100 |
| 107 | 01101011 | 011 | 010110 |
| 108 | 01101100 | 011 | 011000 |
| 109 | 01101101 | 011 | 011010 |
| 110 | 01101110 | 011 | 011100 |
| 111 | 01101111 | 011 | 011110 |
| 112 | 01110000 | 011 | 100000 |
| 113 | 01110001 | 011 | 100010 |
| 114 | 01110010 | 011 | 100100 |
| 115 | 01110011 | 011 | 100110 |
| 116 | 01110100 | 011 | 101000 |
| 117 | 01110101 | 011 | 101010 |
| 118 | 01110110 | 011 | 101100 |
| 119 | 01110111 | 011 | 101110 |
| 120 | 01111000 | 011 | 110000 |
| 121 | 01111001 | 011 | 110010 |
| 122 | 01111010 | 011 | 110100 |
| 123 | 01111011 | 011 | 110110 |
| 124 | 01111100 | 011 | 111000 |
| 125 | 01111101 | 011 | 111010 |
| 126 | 01111110 | 011 | 111100 |
| 127 | 01111111 | 011 | 111110 |

# F I G. 18

| GRAD-ATION | INPUT 8 BITS | 9 BITS DATA MUX C-DAC | |
|---|---|---|---|
| 128 | 10000000 | 100 | 000000 |
| 129 | 10000001 | 100 | 000010 |
| 130 | 10000010 | 100 | 000100 |
| 131 | 10000011 | 100 | 000110 |
| 132 | 10000100 | 100 | 001000 |
| 133 | 10000101 | 100 | 001010 |
| 134 | 10000110 | 100 | 001100 |
| 135 | 10000111 | 100 | 001110 |
| 136 | 10001000 | 100 | 010000 |
| 137 | 10001001 | 100 | 010010 |
| 138 | 10001010 | 100 | 010100 |
| 139 | 10001011 | 100 | 010110 |
| 140 | 10001100 | 100 | 011000 |
| 141 | 10001101 | 100 | 011010 |
| 142 | 10001110 | 100 | 011100 |
| 143 | 10001111 | 100 | 011110 |
| 144 | 10010000 | 100 | 100000 |
| 145 | 10010001 | 100 | 100010 |
| 146 | 10010010 | 100 | 100100 |
| 147 | 10010011 | 100 | 100110 |
| 148 | 10010100 | 100 | 101000 |
| 149 | 10010101 | 100 | 101010 |
| 150 | 10010110 | 100 | 101100 |
| 151 | 10010111 | 100 | 101110 |
| 152 | 10011000 | 100 | 110000 |
| 153 | 10011001 | 100 | 110010 |
| 154 | 10011010 | 100 | 110100 |
| 155 | 10011011 | 100 | 110110 |
| 156 | 10011100 | 100 | 111000 |
| 157 | 10011101 | 100 | 111010 |
| 158 | 10011110 | 100 | 111100 |
| 159 | 10011111 | 100 | 111110 |

# F I G. 19

| GRAD-ATION | INPUT 8 BITS | 9 BITS DATA MUX C-DAC | |
|---|---|---|---|
| 160 | 10100000 | 101 | 000000 |
| 161 | 10100001 | 101 | 000010 |
| 162 | 10100010 | 101 | 000100 |
| 163 | 10100011 | 101 | 000110 |
| 164 | 10100100 | 101 | 001000 |
| 165 | 10100101 | 101 | 001010 |
| 166 | 10100110 | 101 | 001100 |
| 167 | 10100111 | 101 | 001110 |
| 168 | 10101000 | 101 | 010000 |
| 169 | 10101001 | 101 | 010010 |
| 170 | 10101010 | 101 | 010100 |
| 171 | 10101011 | 101 | 010110 |
| 172 | 10101100 | 101 | 011000 |
| 173 | 10101101 | 101 | 011010 |
| 174 | 10101110 | 101 | 011100 |
| 175 | 10101111 | 101 | 011110 |
| 176 | 10110000 | 101 | 100000 |
| 177 | 10110001 | 101 | 100010 |
| 178 | 10110010 | 101 | 100100 |
| 179 | 10110011 | 101 | 100110 |
| 180 | 10110100 | 101 | 101000 |
| 181 | 10110101 | 101 | 101010 |
| 182 | 10110110 | 101 | 101100 |
| 183 | 10110111 | 101 | 101110 |
| 184 | 10111000 | 101 | 110000 |
| 185 | 10111001 | 101 | 110010 |
| 186 | 10111010 | 101 | 110100 |
| 187 | 10111011 | 101 | 110110 |
| 188 | 10111100 | 101 | 111000 |
| 189 | 10111101 | 101 | 111010 |
| 190 | 10111110 | 101 | 111100 |
| 191 | 10111111 | 101 | 111110 |

# F I G. 20

| GRAD- ATION | INPUT 8 BITS | 9 BITS DATA MUX C-DAC | |
|---|---|---|---|
| 192 | 11000000 | 110 | 000000 |
| 193 | 11000001 | 110 | 000010 |
| 194 | 11000010 | 110 | 000100 |
| 195 | 11000011 | 110 | 000110 |
| 196 | 11000100 | 110 | 001000 |
| 197 | 11000101 | 110 | 001010 |
| 198 | 11000110 | 110 | 001100 |
| 199 | 11000111 | 110 | 001110 |
| 200 | 11001000 | 110 | 010000 |
| 201 | 11001001 | 110 | 010010 |
| 202 | 11001010 | 110 | 010100 |
| 203 | 11001011 | 110 | 010110 |
| 204 | 11001100 | 110 | 011000 |
| 205 | 11001101 | 110 | 011010 |
| 206 | 11001110 | 110 | 011100 |
| 207 | 11001111 | 110 | 011110 |
| 208 | 11010000 | 110 | 100000 |
| 209 | 11010001 | 110 | 100010 |
| 210 | 11010010 | 110 | 100100 |
| 211 | 11010011 | 110 | 100110 |
| 212 | 11010100 | 110 | 101000 |
| 213 | 11010101 | 110 | 101010 |
| 214 | 11010110 | 110 | 101100 |
| 215 | 11010111 | 110 | 101110 |
| 216 | 11011000 | 110 | 110000 |
| 217 | 11011001 | 110 | 110010 |
| 218 | 11011010 | 110 | 110100 |
| 219 | 11011011 | 110 | 110110 |
| 220 | 11011100 | 110 | 111000 |
| 221 | 11011101 | 110 | 111010 |
| 222 | 11011110 | 110 | 111100 |
| 223 | 11011111 | 110 | 111110 |

# F I G. 21

| GRAD-ATION | INPUT 8 BITS | 9 BITS DATA MUX C-DAC | |
|---|---|---|---|
| 224 | 11100000 | 111 | 000000 |
| 225 | 11100001 | 111 | 000010 |
| 226 | 11100010 | 111 | 000100 |
| 227 | 11100011 | 111 | 000110 |
| 228 | 11100100 | 111 | 001000 |
| 229 | 11100101 | 111 | 001010 |
| 230 | 11100110 | 111 | 001100 |
| 231 | 11100111 | 111 | 001110 |
| 232 | 11101000 | 111 | 010000 |
| 233 | 11101001 | 111 | 010010 |
| 234 | 11101010 | 111 | 010100 |
| 235 | 11101011 | 111 | 010110 |
| 236 | 11101100 | 111 | 011000 |
| 237 | 11101101 | 111 | 011010 |
| 238 | 11101110 | 111 | 011100 |
| 239 | 11101111 | 111 | 011110 |
| 240 | 11110000 | 111 | 100000 |
| 241 | 11110001 | 111 | 100010 |
| 242 | 11110010 | 111 | 100100 |
| 243 | 11110011 | 111 | 100110 |
| 244 | 11110100 | 111 | 101000 |
| 245 | 11110101 | 111 | 101010 |
| 246 | 11110110 | 111 | 101100 |
| 247 | 11110111 | 111 | 101110 |
| 248 | 11111000 | 111 | 110000 |
| 249 | 11111001 | 111 | 110010 |
| 250 | 11111010 | 111 | 110100 |
| 251 | 11111011 | 111 | 110110 |
| 252 | 11111100 | 111 | 111000 |
| 253 | 11111101 | 111 | 111010 |
| 254 | 11111110 | 111 | 111100 |
| 255 | 11111111 | 111 | 111110 |

# F I G. 22

| GRAD-ATION | INPUT 8 BITS | 9 BITS DATA MUX C-DAC | |
|---|---|---|---|
| 000 | 00000000 | 000 | 000000 |
| 001 | 00000001 | 000 | 000100 |
| 002 | 00000010 | 000 | 001000 |
| 003 | 00000011 | 000 | 001100 |
| 004 | 00000100 | 000 | 010000 |
| 005 | 00000101 | 000 | 010100 |
| 006 | 00000110 | 000 | 011000 |
| 007 | 00000111 | 000 | 011100 |
| 008 | 00001000 | 000 | 100000 |
| 009 | 00001001 | 000 | 100100 |
| 010 | 00001010 | 000 | 101000 |
| 011 | 00001011 | 000 | 101100 |
| 012 | 00001100 | 000 | 110000 |
| 013 | 00001101 | 000 | 110100 |
| 014 | 00001110 | 000 | 111000 |
| 015 | 00001111 | 000 | 111100 |

# F I G. 23

| GRAD-ATION | INPUT 8 BITS | 9 BITS DATA MUX C-DAC | |
|---|---|---|---|
| 016 | 00010000 | 001 | 000000 |
| 017 | 00010001 | 001 | 000010 |
| 018 | 00010010 | 001 | 000100 |
| 019 | 00010011 | 001 | 000110 |
| 020 | 00010100 | 001 | 001000 |
| 021 | 00010101 | 001 | 001010 |
| 022 | 00010110 | 001 | 001100 |
| 023 | 00010111 | 001 | 001110 |
| 024 | 00011000 | 001 | 010000 |
| 025 | 00011001 | 001 | 010010 |
| 026 | 00011010 | 001 | 010100 |
| 027 | 00011011 | 001 | 010110 |
| 028 | 00011100 | 001 | 011000 |
| 029 | 00011101 | 001 | 011010 |
| 030 | 00011110 | 001 | 011100 |
| 031 | 00011111 | 001 | 011110 |
| 032 | 00100000 | 001 | 100000 |
| 033 | 00100001 | 001 | 100010 |
| 034 | 00100010 | 001 | 100100 |
| 035 | 00100011 | 001 | 100110 |
| 036 | 00100100 | 001 | 101000 |
| 037 | 00100101 | 001 | 101010 |
| 038 | 00100110 | 001 | 101100 |
| 039 | 00100111 | 001 | 101110 |
| 040 | 00101000 | 001 | 110000 |
| 041 | 00101001 | 001 | 110010 |
| 042 | 00101010 | 001 | 110100 |
| 043 | 00101011 | 001 | 110110 |
| 044 | 00101100 | 001 | 111000 |
| 045 | 00101101 | 001 | 111010 |
| 046 | 00101110 | 001 | 111100 |
| 047 | 00101111 | 001 | 111110 |

# F I G. 24

| GRAD-ATION | INPUT 8 BITS | 9 BITS DATA MUX C-DAC | |
|---|---|---|---|
| 048 | 00110000 | 010 | 000000 |
| 049 | 00110001 | 010 | 000010 |
| 050 | 00110010 | 010 | 000100 |
| 051 | 00110011 | 010 | 000110 |
| 052 | 00110100 | 010 | 001000 |
| 053 | 00110101 | 010 | 001010 |
| 054 | 00110110 | 010 | 001100 |
| 055 | 00110111 | 010 | 001110 |
| 056 | 00111000 | 010 | 010000 |
| 057 | 00111001 | 010 | 010010 |
| 058 | 00111010 | 010 | 010100 |
| 059 | 00111011 | 010 | 010110 |
| 060 | 00111100 | 010 | 011000 |
| 061 | 00111101 | 010 | 011010 |
| 062 | 00111110 | 010 | 011100 |
| 063 | 00111111 | 010 | 011110 |
| 064 | 01000000 | 010 | 100000 |
| 065 | 01000001 | 010 | 100010 |
| 066 | 01000010 | 010 | 100100 |
| 067 | 01000011 | 010 | 100110 |
| 068 | 01000100 | 010 | 101000 |
| 069 | 01000101 | 010 | 101010 |
| 070 | 01000110 | 010 | 101100 |
| 071 | 01000111 | 010 | 101110 |
| 072 | 01001000 | 010 | 110000 |
| 073 | 01001001 | 010 | 110010 |
| 074 | 01001010 | 010 | 110100 |
| 075 | 01001011 | 010 | 110110 |
| 076 | 01001100 | 010 | 111000 |
| 077 | 01001101 | 010 | 111010 |
| 078 | 01001110 | 010 | 111100 |
| 079 | 01001111 | 010 | 111110 |

# F I G. 25A  F I G. 25B

| GRAD-ATION | INPUT 8 BITS | 9 BITS DATA MUX C-DAC | | GRAD-ATION | INPUT 8 BITS | 9 BITS DATA MUX C-DAC | |
|---|---|---|---|---|---|---|---|
| 080 | 01010000 | 011 | 000000 | 112 | 01110000 | 011 | 100000 |
| 081 | 01010001 | 011 | 000001 | 113 | 01110001 | 011 | 100001 |
| 082 | 01010010 | 011 | 000010 | 114 | 01110010 | 011 | 100010 |
| 083 | 01010011 | 011 | 000011 | 115 | 01110011 | 011 | 100011 |
| 084 | 01010100 | 011 | 000100 | 116 | 01110100 | 011 | 100100 |
| 085 | 01010101 | 011 | 000101 | 117 | 01110101 | 011 | 100101 |
| 086 | 01010110 | 011 | 000110 | 118 | 01110110 | 011 | 100110 |
| 087 | 01010111 | 011 | 000111 | 119 | 01110111 | 011 | 100111 |
| 088 | 01011000 | 011 | 001000 | 120 | 01111000 | 011 | 101000 |
| 089 | 01011001 | 011 | 001001 | 121 | 01111001 | 011 | 101001 |
| 090 | 01011010 | 011 | 001010 | 122 | 01111010 | 011 | 101010 |
| 091 | 01011011 | 011 | 001011 | 123 | 01111011 | 011 | 101011 |
| 092 | 01011100 | 011 | 001100 | 124 | 01111100 | 011 | 101100 |
| 093 | 01011101 | 011 | 001101 | 125 | 01111101 | 011 | 101101 |
| 094 | 01011110 | 011 | 001110 | 126 | 01111110 | 011 | 101110 |
| 095 | 01011111 | 011 | 001111 | 127 | 01111111 | 011 | 101111 |
| 096 | 01100000 | 011 | 010000 | 128 | 10000000 | 011 | 110000 |
| 097 | 01100001 | 011 | 010001 | 129 | 10000001 | 011 | 110001 |
| 098 | 01100010 | 011 | 010010 | 130 | 10000010 | 011 | 110010 |
| 099 | 01100011 | 011 | 010011 | 131 | 10000011 | 011 | 110011 |
| 100 | 01100100 | 011 | 010100 | 132 | 10000100 | 011 | 110100 |
| 101 | 01100101 | 011 | 010101 | 133 | 10000101 | 011 | 110101 |
| 102 | 01100110 | 011 | 010110 | 134 | 10000110 | 011 | 110110 |
| 103 | 01100111 | 011 | 010111 | 135 | 10000111 | 011 | 110111 |
| 104 | 01101000 | 011 | 011000 | 136 | 10001000 | 011 | 111000 |
| 105 | 01101001 | 011 | 011001 | 137 | 10001001 | 011 | 111001 |
| 106 | 01101010 | 011 | 011010 | 138 | 10001010 | 011 | 111010 |
| 107 | 01101011 | 011 | 011011 | 139 | 10001011 | 011 | 111011 |
| 108 | 01101100 | 011 | 011100 | 140 | 10001100 | 011 | 111100 |
| 109 | 01101101 | 011 | 011101 | 141 | 10001101 | 011 | 111101 |
| 110 | 01101110 | 011 | 011110 | 142 | 10001110 | 011 | 111110 |
| 111 | 01101111 | 011 | 011111 | 143 | 10001111 | 011 | 111111 |

# F I G. 26

| GRAD-ATION | INPUT 8 BITS | 9 BITS DATA MUX C—DAC | |
|---|---|---|---|
| 144 | 10010000 | 100 | 000000 |
| 145 | 10010001 | 100 | 000010 |
| 146 | 10010010 | 100 | 000100 |
| 147 | 10010011 | 100 | 000110 |
| 148 | 10010100 | 100 | 001000 |
| 149 | 10010101 | 100 | 001010 |
| 150 | 10010110 | 100 | 001100 |
| 151 | 10010111 | 100 | 001110 |
| 152 | 10011000 | 100 | 010000 |
| 153 | 10011001 | 100 | 010010 |
| 154 | 10011010 | 100 | 010100 |
| 155 | 10011011 | 100 | 010110 |
| 156 | 10011100 | 100 | 011000 |
| 157 | 10011101 | 100 | 011010 |
| 158 | 10011110 | 100 | 011100 |
| 159 | 10011111 | 100 | 011110 |
| 160 | 10100000 | 100 | 100000 |
| 161 | 10100001 | 100 | 100010 |
| 162 | 10100010 | 100 | 100100 |
| 163 | 10100011 | 100 | 100110 |
| 164 | 10100100 | 100 | 101000 |
| 165 | 10100101 | 100 | 101010 |
| 166 | 10100110 | 100 | 101100 |
| 167 | 10100111 | 100 | 101110 |
| 168 | 10101000 | 100 | 110000 |
| 169 | 10101001 | 100 | 110010 |
| 170 | 10101010 | 100 | 110100 |
| 171 | 10101011 | 100 | 110110 |
| 172 | 10101100 | 100 | 111000 |
| 173 | 10101101 | 100 | 111010 |
| 174 | 10101110 | 100 | 111100 |
| 175 | 10101111 | 100 | 111110 |

# F I G. 27

| GRAD-ATION | INPUT 8 BITS | 9 BITS DATA MUX C-DAC | |
|---|---|---|---|
| 176 | 10110000 | 101 | 000000 |
| 177 | 10110001 | 101 | 000010 |
| 178 | 10110010 | 101 | 000100 |
| 179 | 10110011 | 101 | 000110 |
| 180 | 10110100 | 101 | 001000 |
| 181 | 10110101 | 101 | 001010 |
| 182 | 10110110 | 101 | 001100 |
| 183 | 10110111 | 101 | 001110 |
| 184 | 10111000 | 101 | 010000 |
| 185 | 10111001 | 101 | 010010 |
| 186 | 10111010 | 101 | 010100 |
| 187 | 10111011 | 101 | 010110 |
| 188 | 10111100 | 101 | 011000 |
| 189 | 10111101 | 101 | 011010 |
| 190 | 10111110 | 101 | 011100 |
| 191 | 10111111 | 101 | 011110 |
| 192 | 11000000 | 101 | 100000 |
| 193 | 11000001 | 101 | 100010 |
| 194 | 11000010 | 101 | 100100 |
| 195 | 11000011 | 101 | 100110 |
| 196 | 11000100 | 101 | 101000 |
| 197 | 11000101 | 101 | 101010 |
| 198 | 11000110 | 101 | 101100 |
| 199 | 11000111 | 101 | 101110 |
| 200 | 11001000 | 101 | 110000 |
| 201 | 11001001 | 101 | 110010 |
| 202 | 11001010 | 101 | 110100 |
| 203 | 11001011 | 101 | 110110 |
| 204 | 11001100 | 101 | 111000 |
| 205 | 11001101 | 101 | 111010 |
| 206 | 11001110 | 101 | 111100 |
| 207 | 11001111 | 101 | 111110 |

# F I G. 28

| GRAD-ATION | INPUT 8 BITS | 9 BITS DATA MUX C-DAC | |
|---|---|---|---|
| 208 | 11010000 | 110 | 000000 |
| 209 | 11010001 | 110 | 000010 |
| 210 | 11010010 | 110 | 000100 |
| 211 | 11010011 | 110 | 000110 |
| 212 | 11010100 | 110 | 001000 |
| 213 | 11010101 | 110 | 001010 |
| 214 | 11010110 | 110 | 001100 |
| 215 | 11010111 | 110 | 001110 |
| 216 | 11011000 | 110 | 010000 |
| 217 | 11011001 | 110 | 010010 |
| 218 | 11011010 | 110 | 010100 |
| 219 | 11011011 | 110 | 010110 |
| 220 | 11011100 | 110 | 011000 |
| 221 | 11011101 | 110 | 011010 |
| 222 | 11011110 | 110 | 011100 |
| 223 | 11011111 | 110 | 011110 |
| 224 | 11100000 | 110 | 100000 |
| 225 | 11100001 | 110 | 100010 |
| 226 | 11100010 | 110 | 100100 |
| 227 | 11100011 | 110 | 100110 |
| 228 | 11100100 | 110 | 101000 |
| 229 | 11100101 | 110 | 101010 |
| 230 | 11100110 | 110 | 101100 |
| 231 | 11100111 | 110 | 101110 |
| 232 | 11101000 | 110 | 110000 |
| 233 | 11101001 | 110 | 110010 |
| 234 | 11101010 | 110 | 110100 |
| 235 | 11101011 | 110 | 110110 |
| 236 | 11101100 | 110 | 111000 |
| 237 | 11101101 | 110 | 111010 |
| 238 | 11101110 | 110 | 111100 |
| 239 | 11101111 | 110 | 111110 |

# F I G. 29

| GRAD-ATION | INPUT 8 BITS | 9 BITS DATA MUX C-DAC | |
|---|---|---|---|
| 240 | 11110000 | 111 | 000000 |
| 241 | 11110001 | 111 | 000100 |
| 242 | 11110010 | 111 | 001000 |
| 243 | 11110011 | 111 | 001100 |
| 244 | 11110100 | 111 | 010000 |
| 245 | 11110101 | 111 | 010100 |
| 246 | 11110110 | 111 | 011000 |
| 247 | 11110111 | 111 | 011100 |
| 248 | 11111000 | 111 | 100000 |
| 249 | 11111001 | 111 | 100100 |
| 250 | 11111010 | 111 | 101000 |
| 251 | 11111011 | 111 | 101100 |
| 252 | 11111100 | 111 | 110000 |
| 253 | 11111101 | 111 | 110100 |
| 254 | 11111110 | 111 | 111000 |
| 255 | 11111111 | 111 | 111100 |

**European Patent Office**

## EUROPEAN SEARCH REPORT

Application Number

EP 99 10 4314

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | PATENT ABSTRACTS OF JAPAN vol. 097, no. 001, 31 January 1997 -& JP 08 227283 A (SEIKO EPSON CORP), 3 September 1996 * abstract * * figures 1-3,5 * | 1-4 | G09G3/36 |
| A | MINAMIZAKI H ET AL: "P-14: LOW OUTPUT OFFSET, 8 BIT SIGNAL DRIVERS FOR SGA/SVGA TFT -LCDS" PROCEEDINGS OF THE 16TH. INTERNATIONAL DISPLAY RESEARCH CONFERENCE EURODISPLAY 96, BIRMINGHAM, OCT. 1 - 3, 1996, no. CONF. 16, 1 October 1996, pages 247-250, XP000729556 SOCIETY FOR INFORMATION DISPLAY * page 248, left-hand column, last paragraph - page 249, left-hand column, paragraph 2; figure 3B * | 1,2 | |

TECHNICAL FIELDS
SEARCHED (Int.Cl.6)

G09G
H03M

The present search report has been drawn up for all claims

| Place of search | Date of completion of the search | Examiner |
|---|---|---|
| THE HAGUE | 22 June 1999 | Amian, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)